(19) Europäisches Patentamt
European Patent Office
Office européen des brevets

(11) **EP 2 996 249 B1**

(12) **FASCICULE DE BREVET EUROPEEN**

(45) Date de publication et mention de la délivrance du brevet:
**09.01.2019 Bulletin 2019/02**

(51) Int Cl.:
***H03L 7/08*** (2006.01)

(21) Numéro de dépôt: **15184996.5**

(22) Date de dépôt: **14.09.2015**

(54) **BOUCLE À VERROUILLAGE DE PHASE À DEGRÉS DE LIBERTÉ MULTIPLES ET SON PROCÉDÉ DE CONCEPTION ET DE FABRICATION**

PHASENREGELSCHLEIFE MIT MEHREREN FREIHEITSGRADEN, UND IHR PLANUNGS- UND HERSTELLUNGSVERFAHREN

PHASE-LOCKING LOOP WITH MULTIPLE DEGREES OF FREEDOM AND METHOD FOR DESIGNING AND MANUFACTURING SAME

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.09.2014 FR 1458667**

(43) Date de publication de la demande:
**16.03.2016 Bulletin 2016/11**

(73) Titulaires:
 • **COMMISSARIAT À L'ÉNERGIE ATOMIQUE ET AUX ÉNERGIES ALTERNATIVES**
   **75015 Paris (FR)**
 • **Centre National de la Recherche Scientifique**
   **75016 Paris (FR)**
 • **Ecole Centrale de Lyon**
   **69130 Ecully (FR)**
 • **UNIVERSITE CLAUDE BERNARD - LYON 1**
   **69100 Villeurbanne (FR)**

(72) Inventeurs:
 • **PELISSIER, Michael**
   **38000 GRENOBLE (FR)**
 • **KORNIIENKO, Anton**
   **69009 Lyon (FR)**
 • **ZARUDNIEV, Mykhailo**
   **04213 KIEV (UA)**
 • **SCORLETTI, Gérard**
   **69130 ECULLY (FR)**
 • **MOKRENKO, Olesia**
   **38100 GRENOBLE (FR)**

 • **BLANCO, Eric**
   **69150 DECINES-CHARPIEU (FR)**
 • **VILLARD, Patrick**
   **38000 GRENOBLE (FR)**
 • **BILLIOT, Gérard**
   **38330 SAINT-NAZAIRE LES EYMES (FR)**

(74) Mandataire: **Priori, Enrico et al**
**Marks & Clerk France**
**Immeuble "Visium"**
**22, avenue Aristide Briand**
**94117 Arcueil Cedex (FR)**

(56) Documents cités:
**US-A1- 2014 070 859**

 • **GLENN E R COWAN ET AL: "Phase-locked loop architecture for enhanced voltage-controlled oscillator phase-noise suppression", CIRCUITS AND SYSTEMS (ISCAS), 2013 IEEE INTERNATIONAL SYMPOSIUM ON, IEEE, 19 mai 2013 (2013-05-19), pages 2476-2479, XP032446453, DOI: 10.1109/ISCAS.2013.6572381 ISBN: 978-1-4673-5760-9**
 • **SEUNGKEE MIN ET AL: "A 90-nm CMOS 5-GHz Ring-Oscillator PLL With Delay-Discriminator-Based Active Phase-Noise Cancellation", IEEE JOURNAL OF SOLID-STATE CIRCUITS, IEEE SERVICE CENTER, PISCATAWAY, NJ, USA, vol. 48, no. 5, 1 mai 2013 (2013-05-01), pages 1151-1160, XP011505122, ISSN: 0018-9200, DOI: 10.1109/JSSC.2013.2252515**

**Description**

L'invention porte sur une boucle à verrouillage de phase, sur des procédés de conception et de fabrication de telles boucles à verrouillage de phase et sur un récepteur à radiofréquences comprenant une telle boucle à verrouillage de phase.

La boucle à verrouillage de phase (ou PLL, de l'anglais « Phase Locked Loop ») est un circuit électronique bien connu en soi, comprenant un oscillateur à fréquence contrôlée (généralement un oscillateur contrôlé en tension, ou VCO de l'anglais « Voltage Controlled Oscillator ») et un correcteur, ou contrôleur, en boucle fermée générant un signal de pilotage dudit oscillateur pour asservir son signal de sortie à un signal de référence (le correcteur est appelé également « filtre », car dans les réalisations les plus simples il s'agit d'un filtre passe-bas). Elle est utilisée notamment pour réaliser des synthétiseurs de fréquence ; en effet, en introduisant un diviseur de fréquence dans la boucle de rétroaction du correcteur, on obtient un signal de sortie du VCO à une fréquence multiple du signal de référence, généré par exemple par un oscillateur à quartz.

Le signal de sortie du VCO (et donc de la PLL) est inévitablement affecté par un bruit de phase, qui a des origines multiples. Les principales sources de bruit de phase sont l'oscillateur de référence, générant le signal de référence, et l'oscillateur contrôlé en fréquence. Le correcteur est généralement conçu de manière à minimiser l'influence de ces sources de bruit dans la bande spectrale de fonctionnement de la boucle à verrouillage de phase, c'est-à-dire, à rejeter le bruit de phase dans une bande des fréquences donnée.

Comme cela sera expliqué plus en détail dans la suite, cependant, dans une boucle à verrouillage de phase connue de l'art antérieur il existe une limite fondamentale au rejet du bruit de phase. Plus précisément, il est possible de démontrer que le correcteur ne peut pas filtrer efficacement, à une même fréquence, le bruit de phase de référence et celui dû au VCO. Pour obtenir un signal de sortie à faible bruit de phase malgré cette limitation intrinsèque, il est nécessaire d'utiliser des VCOs et des oscillateurs de référence de très haute qualité - et donc couteux - et difficilement intégrables sur des technologies silicium et/ou des correcteurs d'ordre élevé. Même en prenant ces précautions, les limitations intrinsèques de l'architecture conventionnelle des boucles à verrouillage de phase empêchent un filtrage du bruit suffisamment efficace pour certaines applications. La publication de la demande de brevet US 2014/0070859 A1 divulgue une boucle à verrouillage de phase comprenant des moyens de corrections du bruit du signal de référence.

L'invention vise à remédier à cet inconvénient de l'art antérieur et à procurer une boucle à verrouillage de phase présentant un meilleur rejet du bruit de phase sans avoir nécessairement recours à des VCOs et des oscillateurs de référence de très haute qualité et/ou à un correcteur d'ordre élevé.

Conformément à l'invention, un tel but est atteint grâce à une boucle à verrouillage de phase, ou PLL, « à degrés de liberté multiples ». On entend par là une PLL comprenant au moins deux correcteurs ayant des signaux d'entrée linéairement indépendants. Il convient de comprendre que ces correcteurs peuvent être réalisés sous la forme d'un dispositif physique unique, mais présentant au moins deux entrées, au moins une sortie et deux relations entrée/sortie (fonctions de transfert) linéairement indépendantes.

Les documents [ChM-2007] et [SNI-2012] divulguent des PLL qui peuvent être considérées à « deux degrés de liberté ».

Dans le cas du document [ChM-2007], une PLL de type conventionnel est modifiée par l'ajout d'un chemin de signal réalisant une commande par anticipation (« feed-forward » en anglais) dans le but d'augmenter la vitesse de réponse de la boucle. Ce chemin de signal présente un gain constant en fonction de la fréquence, ce qui ne permet aucune amélioration des performances de rejet du bruit de phase. La possibilité d'utiliser un correcteur en commande par anticipation présentant un gain variable en fonction de la fréquence est évoquée, mais aucune méthode de conception d'un tel correcteur n'est mentionnée. Par ailleurs, le document ne suggère pas qu'un tel correcteur pourrait être utilisé pour réduire le bruit de phase du signal de sortie.

Le document [SNI-2012] divulgue également une PLL comprenant, en plus d'un correcteur conventionnel, un chemin de signal réalisant une commande par anticipation. Ce dernier comprend un estimateur de fréquence suivi d'un filtre passe-bas. Dans ce cas non plus il n'est pas question d'améliorer le rejet du bruit de phase, mais seulement d'augmenter la rapidité de synchronisation et d'assurer la stabilité de la boucle à verrouillage de phase.

Un objet de l'invention permettant d'atteindre le but mentionné ci-dessus est un procédé de conception d'une boucle à verrouillage de phase, du type comprenant ;

- un oscillateur à fréquence contrôlée ;
- un comparateur de phase, configuré pour déterminer une différence de phase entre un signal de sortie dudit oscillateur à fréquence contrôlée et un signal de référence ;
- un correcteur, dit premier correcteur, configuré pour recevoir en entrée un signal représentatif de ladite différence de phase et pour générer à sa sortie un signal dit premier signal de correction ;
- au moins un autre correcteur, dit deuxième correcteur, configuré pour recevoir en entrée un signal représentatif de ou affecté par un bruit de phase dudit signal de référence ou dudit signal de sortie dudit oscillateur à fréquence contrôlée et pour générer à sa sortie un signal dit deuxième signal de correction ; et

- un moyen de génération d'un signal d'asservissement dudit oscillateur à fréquence contrôlée à partir desdits premier et deuxième signaux de correction ;

ledit procédé comprenant une étape de détermination de fonctions de transfert desdits correcteurs et étant caractérisé en ce que ladite étape est mise en oeuvre, au moyen d'un ordinateur, par application de la méthode $H_\infty$ en utilisant :

- en entrée, une fonction de pondération d'un bruit de phase dudit oscillateur à fréquence contrôlée, dite première fonction de pondération, et une fonction de pondération d'un bruit de phase d'un signal de référence, dite deuxième fonction de pondération, déterminées à partir de densités spectrales de puissance nominales desdits bruit ; et
- en sortie, au moins une fonction de pondération d'un bruit de phase d'un signal de sortie de la boucle de verrouillage de phase ou d'un erreur de suivi dudit signal de référence, dite troisième fonction de pondération, déterminée à partir d'un gabarit de densité spectrale de puissance de bruit de phase dudit signal de sortie devant être respecté.

Selon différents modes de réalisation d'un tel procédé :

- Ladite étape de détermination de fonctions de transfert desdits correcteurs peut comprendre les sous-étapes suivantes :

    a) déterminer une densité spectrale de puissance nominale dudit signal de référence ;
    b) déterminer une densité spectrale de puissance nominale du bruit de phase dudit oscillateur à fréquence contrôlée ;
    c) déterminer un gabarit de densité spectrale de puissance de bruit de phase dudit signal de sortie devant être respecté ;
    d) à partir desdites densités spectrales de puissance nominale et dudit gabarit de densité spectrale de puissance, déterminer au moins lesdites première, deuxième et troisième fonctions de pondération ;
    e) construire un système augmenté desdites pondération ; et
    f) appliquer la méthode $H_\infty$ audit système augmenté pour synthétiser les fonctions de transfert desdits correcteurs.

- Ladite étape d) peut comprendre également la détermination d'une fonction de pondération en sortie, dite quatrième fonction de pondération, de la densité spectrale de puissance dudit signal d'asservissement à partir d'un gabarit de densité spectrale de puissance dudit signal d'asservissement à respecter.
- Le procédé peut comprendre également une sous-étape d') de simplification des fonctions de pondération déterminées lors de la sous-étape d), les fonctions de pondération ainsi simplifiées étant utilisées lors de ladite sous-étape e), ladite simplification étant mise en oeuvre en approchant lesdites fonctions de pondérations par des fonctions de transfert d'ordre plus faible et de module moins élevé au moins sur une plage spectrale de fonctionnement de la boucle à verrouillage de phase.
- Le procédé peut comprendre également une sous-étape g) de simplification des fonctions de transfert synthétisées lors de ladite sous-étape f), ladite simplification étant mise en oeuvre en approchant lesdites fonctions de transfert par des fonctions de transfert d'ordre plus faible.
- Ladite étape f) peut être mise en oeuvre avec une contrainte additionnelle, selon laquelle le module de la fonction de transfert entre ledit signal de sortie dudit oscillateur à fréquence contrôlée et ledit signal de référence présente, dans au moins une plage spectrale, une pente supérieure ou égale à +20 db/décade et de préférence à 40 dB/décade.
- Ladite boucle à verrouillage de phase peut comprendre au moins un autre correcteur, dit troisième correcteur, configuré pour recevoir en entrée un signal représentatif de ou affecté par un bruit de phase généré à l'intérieur de ladite boucle, autre que ledit bruit de phase dudit signal de sortie dudit oscillateur à fréquence contrôlée, et pour générer à sa sortie un signal dit troisième signal de correction, ledit moyen de génération d'un signal d'asservissement dudit oscillateur à fréquence contrôlée étant configuré pour générer ledit signal d'asservissement également à partir dudit troisième signal de correction. ladite étape de détermination de fonctions de transfert desdits correcteurs, mise en oeuvre par ladite méthode $H_\infty$, utilisant en entrée également une fonction de pondération dudit bruit de phase autre que ledit bruit de phase dudit signal de sortie dudit oscillateur à fréquence contrôlée, également déterminée à partir de la densité spectrale de puissance dudit bruit.

Un autre objet de l'invention est un procédé de fabrication d'une boucle à verrouillage de phase, du type comprenant ;

- un oscillateur à fréquence contrôlée ;

- un comparateur de phase pour déterminer une différence de phase entre un signal de sortie dudit oscillateur à fréquence contrôlée et un signal de référence ;
- un correcteur, dit premier correcteur, configuré pour recevoir en entrée un signal représentatif de ladite différence de phase et pour générer à sa sortie un signal dit premier signal de correction ;
- au moins un autre correcteur, dit deuxième correcteur, configuré pour recevoir en entrée un signal représentatif de ou affecté par un bruit de phase dudit signal de référence ou dudit signal de sortie dudit oscillateur à fréquence contrôlée et pour générer à sa sortie un signal dit deuxième signal de correction ; et
- un moyen de génération d'un signal d'asservissement dudit oscillateur à fréquence contrôlée à partir desdits premier et deuxième signaux de correction ;

ledit procédé comprenant :

- une étape de conception de ladite boucle à verrouillage de phase ; et
- une étape de réalisation physique de la boucle à verrouillage de phase ainsi conçue ;

caractérisé en ce que ladite étape de conception est mise en oeuvre par un procédé tel que défini ci-dessus.

Avantageusement, ladite boucle à verrouillage de phase peut comprendre au moins un autre correcteur, dit troisième correcteur, configuré pour recevoir en entrée un signal représentatif de ou affecté par un bruit de phase généré à l'intérieur de ladite boucle, autre que ledit bruit de phase dudit signal de sortie dudit oscillateur à fréquence contrôlée, et pour générer à sa sortie un signal dit troisième signal de correction, ledit moyen de génération d'un signal d'asservissement dudit oscillateur à fréquence contrôlée étant configuré pour générer ledit signal d'asservissement également à partir dudit troisième signal de correction.

Encore un autre objet de l'invention est une boucle à verrouillage de phase comprenant :

- un oscillateur à fréquence contrôlée adapté pour générer un signal de sortie présentant un bruit de phase ;
- un comparateur de phase pour déterminer une différence de phase entre un signal de sortie dudit oscillateur à fréquence contrôlée et un signal de référence, ledit signal de référence présentant un bruit de phase ;
- un correcteur, dit premier correcteur, configuré pour recevoir en entrée un signal représentatif de ladite différence de phase et pour générer à sa sortie un signal dit premier signal de correction ;
- au moins un autre correcteur, dit deuxième correcteur, configuré pour recevoir en entrée un signal représentatif de ou affecté par le bruit de phase dudit signal de référence ou dudit signal de sortie dudit oscillateur à fréquence contrôlée et pour générer à sa sortie un signal dit deuxième signal de correction ; et
- un moyen de génération d'un signal d'asservissement dudit oscillateur à fréquence contrôlée à partir desdits premier et deuxième signaux de correction ;

caractérisée en ce que lesdits premier et deuxième correcteur présentent des fonctions de transfert non constantes, choisies de manière à permettre le rejet, dans une même bande de fréquence, du bruit de phase dudit signal de référence et du bruit de phase dudit signal de sortie dudit oscillateur à fréquence contrôlée et susceptibles d'être obtenues par application de la méthode $H_\infty$ en utilisant :

- en entrée, une fonction de pondération ($W_b$) du bruit de phase dudit oscillateur à fréquence contrôlée, dite première fonction de pondération, et une fonction de pondération ($W_{bref}$) du bruit de phase dudit signal de référence, dite deuxième fonction de pondération, déterminées à partir de densités spectrales de puissance nominales desdits bruit ; et
- en sortie, au moins une fonction de pondération ($W_\varphi, W_\varepsilon$) d'un bruit de phase d'un signal de sortie de la boucle de verrouillage de phase ou d'un erreur de suivi dudit signal de référence, dite troisième fonction de pondération, déterminée à partir d'un gabarit de densité spectrale de puissance de bruit de phase dudit signal de sortie devant être respecté.

Selon différents modes de réalisation d'une telle boucle à verrouillage de phase

- Ledit deuxième correcteur peut être configuré pour recevoir en entrée : soit un signal représentatif de la phase dudit signal de référence ; soit une estimation du bruit de phase dudit signal de référence.

- Ladite boucle à verrouillage de phase peut comprendre également un circuit de détermination d'une estimation du bruit de phase dudit signal de référence comprenant : un module retardateur, configuré pour générer une version retardée d'un temps $T_d$ dudit signal de référence ; un module déphaseur, configuré pour générer une version dudit signal de référence présentant un déphasage $\delta\varphi$, avec

$$\delta\varphi - \omega_{ref} T_d = \frac{\pi}{2} + 2\pi k,$$

$k \in Z$, où $\omega_{ref}$ est la fréquence dudit signal de référence ; et un mélangeur configuré pour recevoir en entrée les signaux de sortie desdits modules retardateur et déphaseur et pour fournir à sa sortie leur produit ; ledit deuxième correcteur étant configuré pour recevoir en entrée ladite estimation du bruit de phase dudit signal de référence.

- Ledit deuxième correcteur peut être configuré pour recevoir en entrée : soit un signal représentatif de la phase dudit signal de sortie dudit oscillateur à fréquence contrôlée ; soit une estimation du bruit de phase dudit signal de sortie dudit oscillateur à fréquence contrôlée.

- Ladite boucle à verrouillage de phase peut comprendre également un circuit de détermination d'une estimation du bruit de phase dudit signal de sortie comprenant : un module retardateur, configuré pour générer une version retardée d'un temps $T_d$ dudit signal de sortie ; un module déphaseur, configuré pour générer une version dudit signal de

$$\delta\varphi - \omega_o T_d = \frac{\pi}{2} + 2\pi k,$$

sortie présentant un déphasage $\delta\varphi$, avec $k \in Z$, où $\omega_o$ est la fréquence dudit signal de sortie ; et un mélangeur configuré pour recevoir en entrée les signaux de sortie desdits modules retardateur et déphaseur et pour fournir à sa sortie leur produit ; ledit deuxième correcteur étant configuré pour recevoir en entrée ladite estimation du bruit de phase dudit signal de sortie.

- Ladite boucle à verrouillage de phase peut comprendre également au moins un autre correcteur, dit troisième correcteur, configuré pour recevoir en entrée :un signal représentatif de ou affecté par un bruit de phase généré à l'intérieur de ladite boucle, autre que ledit bruit de phase dudit signal de sortie dudit oscillateur à fréquence contrôlée, et pour générer à sa sortie un signal dit troisième signal de correction, ledit moyen de génération d'un signal d'asservissement dudit oscillateur à fréquence contrôlée étant configuré pour générer ledit signal d'asservissement également à partir dudit troisième signal de correction.

Encore un autre objet de l'invention est une chaine de réception à radiofréquence comprenant : un préamplificateur à radiofréquence ; un mélangeur configuré pour recevoir en entrée un signal de sortie dudit préamplificateur à radiofréquence et un signal sinusoïdal de conversion de fréquence, et pour fournir en sortie un signal à fréquence intermédiaire ; et un circuit de génération dudit signal sinusoïdal de conversion de fréquence ; dans laquelle ledit circuit de génération dudit signal sinusoïdal de conversion de fréquence comprend une telle boucle à verrouillage de phase, utilisant ledit mélangeur en tant que mélangeur dudit circuit de détermination d'une estimation du bruit de phase dudit signal de sortie, et un oscillateur configuré pour générer ledit signal de référence.

D'autres caractéristiques, détails et avantages de l'invention ressortiront à la lecture de la description faite en référence aux dessins annexés donnés à titre d'exemple et qui représentent, respectivement :

- Les figures 1 et 2, deux représentations d'un schéma fonctionnel d'un PLL « à un degré de liberté » connue de l'art antérieur ;
- La figure 3, un graphique permettant de comprendre pourquoi une PLL du type des figures 1 et 2 ne peut pas filtrer efficacement toutes les contributions au bruit de phase de son signal de sortie ;
- Les figures 4a et 4b, les schémas fonctionnels de deux variantes d'une PLL « à deux degrés de liberté » selon un premier mode de réalisation de l'invention utilisant un deuxième correcteur en mode de commande par anticipation (« *feed forward* » en anglais) ;
- Les figures 5a et 5b, les schémas fonctionnels de deux variantes d'une PLL « à deux degrés de liberté » selon un deuxième mode de réalisation de l'invention utilisant un deuxième correcteur en mode de rétroaction ;
- Les figures 6a, 6b et 7, des gabarits fréquentiels servant de données d'entrée d'un procédé de conception selon un mode de réalisation de l'invention ;
- Les figures 8 et 9, des contraintes sur les fonctions de transfert en boucle fermées dérivées desdits gabarits fréquentiels et utilisés dans un procédé de conception selon un mode de réalisation de l'invention ;
- La figure 10, un schéma fonctionnel d'une PLL du type de la figure 4a, « augmentée » des fonctions de pondération visant à rejeter le bruit de phase selon les gabarits des figures 8 et 9 ;
- La figure 11, une représentation condensée du schéma fonctionnel de la figure 10 ;
- La figure 12a, un schéma fonctionnel d'une PLL du type de la figure 4a, « augmentée » de fonctions de pondération visant à rejeter le bruit de phase et, en outre, à imposer une contrainte sur le signal d'asservissement du VCO ;
- La figure 12b, une représentation condensée du schéma fonctionnel de la figure 12a ;
- Les figures 13a, 13b et 13c, des fonctions de transfert du bruit de phase du VCO et du signal de référence obtenues en utilisant les pondérations de la figure 12a, ainsi que les contraintes que ces fonctions de transfert doivent respecter ;

- La figure 13d, les diagrammes de Bode de ces pondérations ;
- Les figures 14 et 15, les fonctions de transfert des correcteurs synthétisés en utilisant les pondérations de la figure 12a ;
- Les figures 16 à 19, diverses graphiques illustrant le résultat technique de l'invention ;
- La figure 20, le schéma fonctionnel d'un circuit de détermination d'une estimation du bruit de phase d'un signal ;
- La figure 21, le schéma d'une PLL du type de la figure 4b, utilisant un circuit de détermination d'une estimation du bruit de phase du signal de référence selon la figure 20 ;
- La figure 22 un correcteur PID analogique pouvant être utilisé dans la PLL de la figure 21 ;
- La figure 23, le schéma d'une PLL du type de la figure 5b, utilisant un circuit de détermination d'une estimation du bruit de phase du signal de sortie selon la figure 20 ;
- La figure 24, le schéma fonctionnel d'une chaine de réception à radiofréquence comprenant une PLL selon la figure 23 ;
- La figure 25, le schéma fonctionnel d'une PLL à trois degrés de liberté utilisant un deuxième correcteur en mode de commande par anticipation et un troisième correcteur en mode de rétroaction ;
- La figure 26, l'application de la présente invention à une PLL entièrement numérique ; et
- La figure 27, le schéma fonctionnel d'une PLL à cinq degrés de liberté.

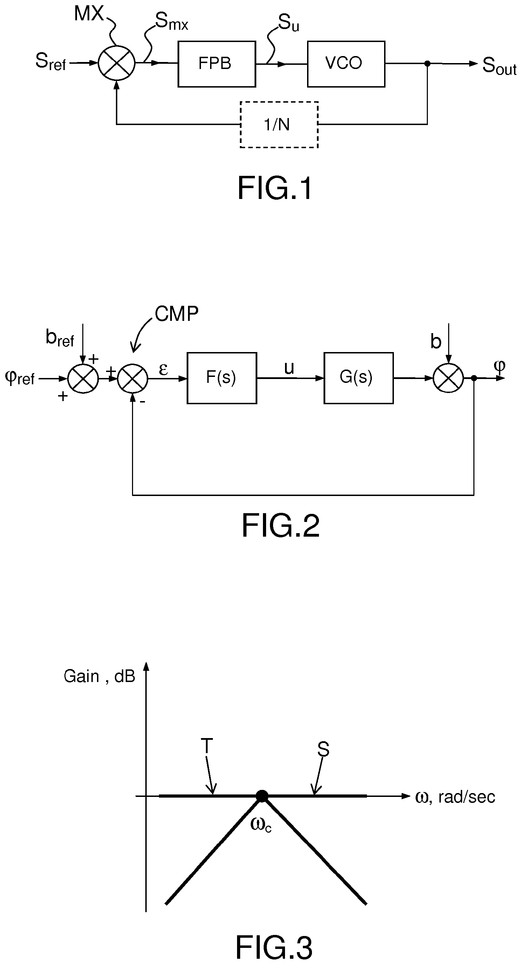

La figure 1 montre le schéma fonctionnel d'une PLL analogique, recevant à son entrée un signal de référence $s_{ref}=V_{ref} \cdot \sin[\varphi_{ref}(t)]$, Le signal de référence et le signal de sortie de la PLL, $s_{out}=V_{out} \cdot \cos[cp(t)]$ sont fournis aux entrées d'un mélangeur MX, qui fournit à sa sortie leur produit : $s_{mx} \propto \sin[(\varphi_{ref}(t)) \cdot \cos[\varphi(t)] \propto \sin[\varphi_{ref}(t)+\varphi(t)] \cdot \sin[\varphi_{ref}(t)-\varphi(t)]$. On suppose que $\varphi_{ref}(t)$ et $\varphi_{out}(t)$ sont essentiellement des rampes de phase, ce qui signifie que les signaux de référence et de sortie s'écartent peu de sinusoïdes parfaites. Un filtre passe-bas FPB supprime la composante « haute fréquence » $\sin[\varphi_{ref}(t)+\varphi(t)]$ de $s_{mx}$ ; à la sortie du filtre on obtient donc le signal $s_u \propto \sin[\varphi_{ref}(t)-\varphi(t)]$. En supposant $\varphi_{ref}(t)\tilde{=}\varphi(t)$ - ce qui est normalement le cas en régime permanent - on peut approcher le sinus par l'arc, ce qui donne : $s_u \propto \varphi_{ref}(t)-\varphi(t)=\Delta\varphi(t)$. En d'autres termes, le signal $s_u$ est proportionnel à la différence instantanée de phase entre le signal de référence et le signal de sortie. Ce signal $s_u$ pilote un oscillateur contrôlé en tension VCO, qui génère le signal de sortie $s_{out}$. Si le filtre, ou correcteur, FPB est dimensionné de manière opportune, le VCO est asservi au signal de référence, c'est-à-dire que $\varphi(t)$ suit fidèlement $\varphi_{ref}(t)$. Si un bloc diviseur de fréquence (représenté en trait pointillé sur la figure 1, N étant le facteur de division) est introduit sur le chemin de rétroaction, entre le signal de sortie et le mélangeur, $\varphi(t)$ suivra $N\varphi_{ref}(t)$, réalisant ainsi une multiplication de la fréquence du signal de référence.

En régime de petits signaux (c'est-à-dire pour $\varphi_{ref}(t)\tilde{=}\varphi(t)$), le fonctionnement de la PLL peut être illustré par le schéma de la figure 2. Ce schéma ne doit pas être confondu avec un schéma électrique : ses signaux d'entrée et de sortie ne sont pas des valeurs de tension, mais directement les phases $\varphi_{ref}$ et $\varphi$. Le mélangeur est modélisé par un comparateur de phase CMP, fournissant à sa sortie un signal différence « ε », et le VCO par un bloc présentant une fonction de transfert G(s), typiquement un intégrateur. Le filtre passe-bas, caractérisé par une fonction de transfert F(s) et générant un signal d'asservissement « u », sera appelé dans la suite « correcteur » pour souligner le fait qu'il assure d'autres fonctions que le filtrage passe-bas, comme la stabilisation de la boucle, la synchronisation de la PLL, la détermination d'une bande passante minimale etc.

Le signal $\varphi_{ref}$ peut être considéré comme le signal utile sur lequel la sortie $\varphi$ de la PLL doit être asservie. Le correcteur doit donc assurer cet asservissement. Par contre, les signaux de bruit b et $b_{ref}$ sont des signaux parasites - dus respectivement au VCO et à l'oscillateur engendrant le signal de référence - qui doivent être filtrés de telle façon que leurs contributions à la sortie de la PLL $\varphi$ soit la plus faible possible tout en garantissant l'asservissement. Le choix du correcteur F(s) qui garantit ces propriétés de performance de la PLL sera appelé par la suite l'optimisation du bruit de phase de la PLL. D'autres sources de bruits de phase existent (bruit de comparateur de phase, de diviseur de fréquence, etc.) mais leur contribution est généralement moins importante.

L'asservissement de la PLL peut être réalisé via une implémentation analogique ou de type numérique.

Etant donné que l'exigence de filtrage du bruit est naturellement exprimée sous forme de gabarit sur la Densité Spectrale de Puissance (DSP) des signaux, il est intéressant d'exprimer la DSP de la sortie de la PLL par rapport aux DSP de signaux d'entrée considérés. On obtient donc, en considérant que le bruit de VCO, le bruit de la référence et le signal de référence ne sont pas corrélés :

$$S_{\varphi}(j2\pi f) = \left| \frac{1}{1+G(j2\pi f)F(j2\pi f)} \right|^2 S_b(j2\pi f) + \left| \frac{F(j2\pi f)G(j2\pi f)}{1+G(j2\pi f)F(j2\pi f)} \right|^2 S_{bref}(j2\pi f) +$$

$$+ \left| \frac{F(j2\pi f)G(j2\pi f)}{1+G(j2\pi f)F(j2\pi f)} \right|^2 S_{\varphi ref}(j2\pi f)$$

$$(1)$$

où $S_x$ est la DSP du signal « x », avec « x » pouvant prendre les valeurs : $\varphi$, $\varphi_{ref}$, b, $b_{ref}$, f la fréquence exprimé en Hz.

L'équation (1) met en évidence les modules au carré des réponses fréquentielles des fonctions de transfert qui relient le signal de phase de référence $\varphi_{ref}$ et les bruits de phase de la référence, $b_{ref}$, et du VCO, b, avec la sortie de la PLL. La fonction de transfert entre le bruit du VCO, b, et la sortie de la PLL $\varphi$, sera notée $S(s) = \dfrac{1}{1+G(s)F(s)}$ et sera appelée « fonction de sensibilité ». La fonction de transfert entre le bruit de phase de la référence $b_{ref}$ (ou de manière équivalent le signal de phase de la référence $\varphi_{ref}$) et la sortie de la PLL sera notée $T(s) = \dfrac{G(s)F(s)}{1+G(s)F(s)}$ et sera appelée « fonction de sensibilité complémentaire ».

Il est facile de se rendre compte que :

$$S(s) + T(s) = \frac{1}{1+G(s)F(s)} + \frac{G(s)F(s)}{1+G(s)F(s)} = 1 \qquad (2)$$

Généralement la fonction de transfert S est celle d'un filtre passe haut pour pouvoir filtrer la contribution du bruit b du VCO autour de la fréquence porteuse de la PLL. En conséquence, au vu de la relation (2), la fonction de transfert T représente un filtre passe bas, qui est responsable de la mise en forme du bruit de référence $b_{ref}$. De plus, on peut démontrer qu'à cause de la relation (2), et quel que soit le correcteur F(s) choisi assurant la stabilité de la PLL, il n'est pas possible pour une fréquence donnée que les modules des réponses fréquentielles de deux fonctions de transfert S(s) et T(s) soient faibles tous les deux i.e. $|S(j2\pi f)| << 1$ et $|(j2\pi f)| << 1$ pour $f \in [f_{min}, f_{max}]$. Si le module de la réponse fréquentielle de la fonction de sensibilité S(s) est faible pour une fréquence donnée ($|S(j2\pi f)| << 1$), il est inévitable que le module de la réponse fréquentielle de la fonction de sensibilité complémentaire T(s) soit proche de 1 ($|T(j2\pi f)| \approx 1$) pour que la relation (2) soit respectée (voir la Fig.3, où S et T sont, respectivement, un filtre passe-haut et un filtre passe-bas avec une même pulsation de coupure, $\omega_c$). Réciproquement, si $|T(j2\pi f)| << 1$ alors $|S(j2\pi f)| \approx 1$. Ainsi, la relation (2) implique une limitation fondamentale des performances d'une PLL selon l'art antérieur en termes de filtrage du bruit de phase. En effet, si les modules des fonctions de transfert S et T ne peuvent pas être faibles à une même fréquence ou dans une même plage de fréquences, il n'est pas possible de filtrer les deux sources de bruit b et $b_{ref}$ au même temps à cette fréquence ou dans cette plage de fréquences. Cette limitation est inhérente à la structure de la boucle fermée à un degré de liberté représentée sur les figures 1 et 2 ; elle oblige à accepter un compromis privilégiant le filtrage d'une source de bruit par rapport à l'autre. L'invention permet de surmonter cette limitation fondamentale en introduisant au moins un degré de liberté supplémentaire dans l'asservissement du VCO. Cela permet de contrôler et d'optimiser séparément les contraintes vis à vis de chacune des sources de bruit de la PLL, et donc de garantir que les deux fonctions de transfert reliant les sources de bruit de phase avec la sortie de la PLL puissent avoir des réponses fréquentielles à gains faibles au même temps sur une certaine plage de fréquence afin de réaliser le filtrage de bruit.

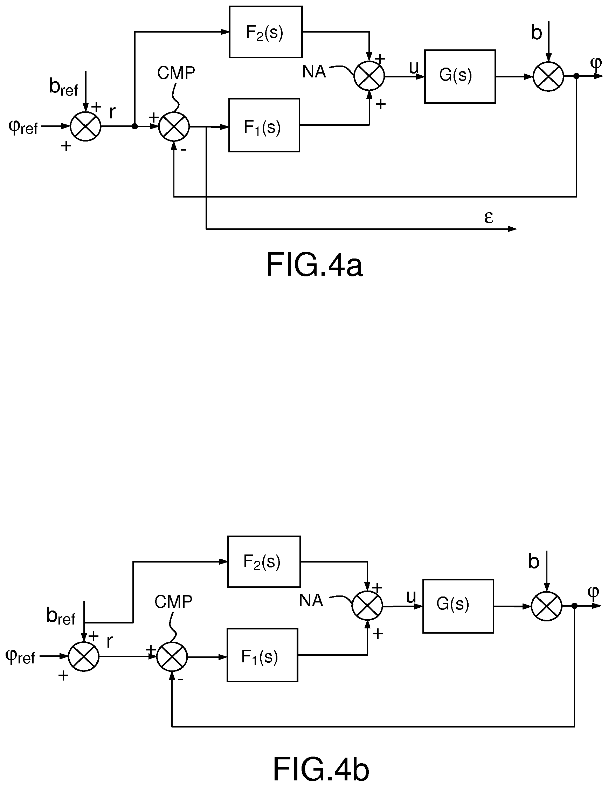

La figure 4a illustre un premier mode de réalisation de l'invention qui se différencie de celui de la figure 2 par la présence, en plus du correcteur $F_1$ agencé entre le comparateur de phase et le VCO (appelé par la suite « premier correcteur »), d'un deuxième correcteur $F_2$ connecté en mode de commande par anticipation (« *feed-forward* » en anglais), recevant à son entrée la phase bruitée du signal de référence : $r = \varphi_{ref} + b_{ref}$. Les signaux de sortie des deux correcteurs (signaux de correction) sont sommés par un noeud additionneur NA pour fournir le signal d'asservissement du VCO, u. Plus généralement, les signaux de correction peuvent être combinés - linéairement ou pas - pour fournir le signal d'asservissement u. Dans ce mode de réalisation, le premier correcteur $F_1$ agit à la fois sur le bruit du VCO et sur le bruit de la référence, tandis que le deuxième correcteur $F_2$ agit spécifiquement sur le bruit de la référence.

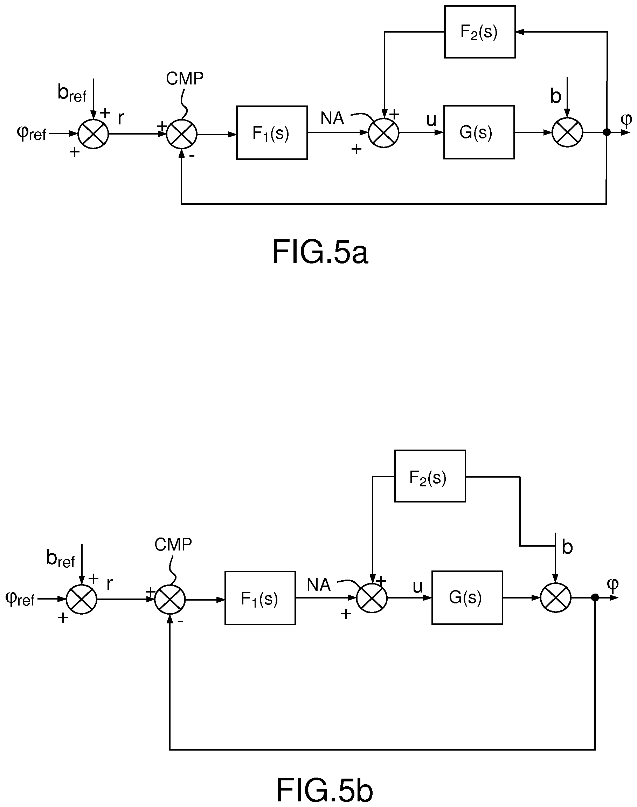

La figure 5a illustre un deuxième mode de réalisation de l'invention qui se différencie de celui de la figure 4a par le fait que le deuxième correcteur est connecté en mode de rétroaction (« feedback » en anglais), recevant à son entrée le signal de sortie bruité φ. Dans ce mode de réalisation, le premier correcteur $F_1$ agit à la fois sur le bruit du VCO et sur le bruit de la référence, tandis que le deuxième correcteur $F_2$ agit spécifiquement sur le bruit du VCO.

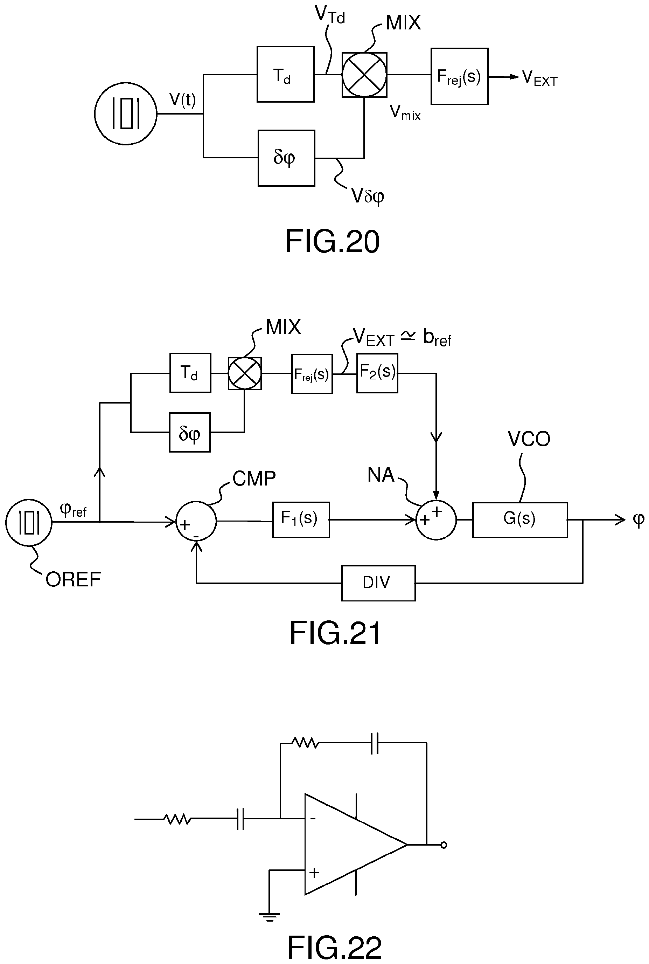

Il est cependant difficile de réaliser des PLL basées sur ces deux schémas de principes car il s'avère en pratique délicat de mesurer directement le signal de bruit de phase en entrée du correcteur $F_2(s)$ ; en effet, le signal « r » qui apparait sur les schémas 4a et 5a n'est pas, en réalité, mesurable dans un circuit électronique. Pour cette raison, il est généralement préférable d'utiliser un circuit additionnel qui reçoit en entrée un signal de tension périodique bruité et fournit à sa sortie une estimation du bruit de phase affectant ce signal (pour un mode de réalisation d'un tel circuit, voir la figure 20 et la partie correspondante de la description). Cette estimation du bruit de phase peut être avantageusement utilisé en entrée du deuxième correcteur $F_2(s)$, comme illustré sur les figures 4b (pour le cas d'une connexion en commande par anticipation) et 5b (pour le cas d'une connexion en rétroaction).

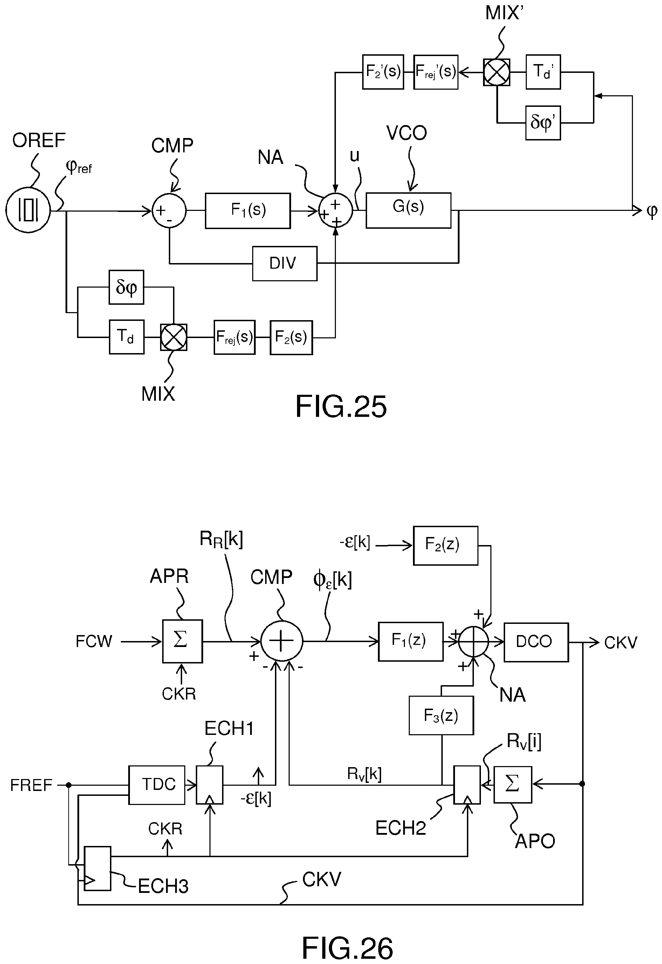

Il est également possible de combiner commande par anticipation et rétroaction pour réaliser une PLL à trois degrés de liberté ; une telle PLL sera décrite plus loin en référence à la figure 25.

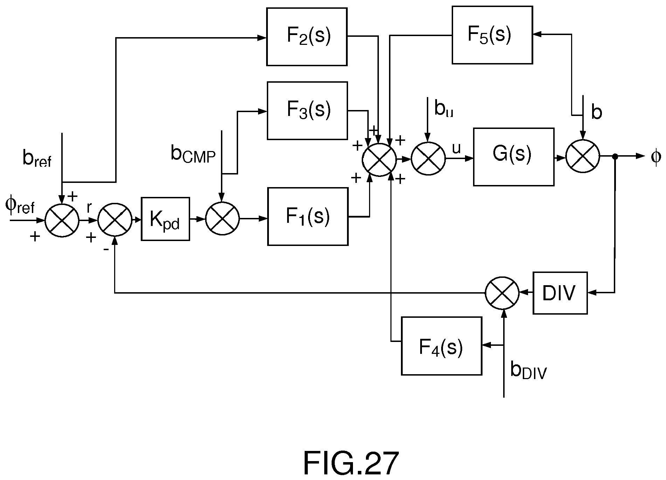

Il est également possible de réaliser des boucles de verrouillage de phase à plus de trois degrés de liberté pour corriger d'autres sources de bruit que le signal de référence et le VCO, par exemple le bruit introduit par un diviseur de fréquence. A titre d'exemple, la figure 27 illustre le schéma de principe d'une PLL à cinq degrés de liberté comprenant, outre les correcteurs $F_1$ et $F_2$ déjà présents dans la PLL à deux degrés de liberté de la figure 4b, un troisième correcteur $F_3$, un quatrième correcteur $F_4$ et un cinquième correcteur $F_5$. Ces degrés de liberté additionnels permettent de rejeter, outre les bruits du VCO et de la référence, le bruit du comparateur $b_{CMP}$, celui du diviseur de fréquence DIV, $b_{DIV}$ et le bruit total introduit par les filtres, $b_u$.

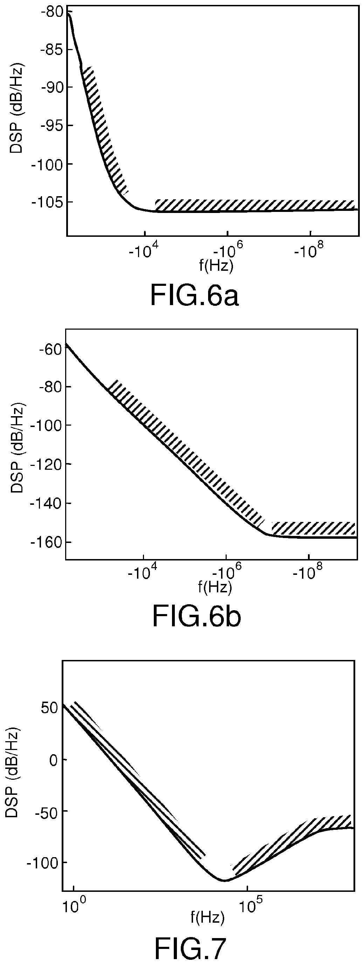

L'invention propose également un procédé systématique de conception (synthèse des fonctions de transfert) des correcteurs qui sera décrit en détail ci-après, à l'aide des figures 6a à 19. Ce procédé utilise la méthode « $H_\infty$ » (ou « H-infini »), connue de l'art antérieur, permettant de satisfaire une contrainte sur le bruit de phase en sortie exprimée par un gabarit de DSP dudit bruit de phase - et éventuellement une ou plusieurs autres contraintes - étant donnés un oscillateur de référence et un oscillateur à fréquence contrôlé avec leurs propres performances en termes de bruit de phase, également exprimées par des gabarits de DSP. Avantageusement, cette méthode est mise en oeuvre par ordinateur, ce qui signifie qu'au moins une de ses étapes est mise en oeuvre en utilisant un ordinateur. Le recours à un tel procédé systématique de conception est d'autant plus nécessaire que le nombre de degrés de liberté de la PLL est élevé. Sans une approche systématique, le dimensionnement des cinq correcteurs de la PLL de la figure 27, par exemple, serait extrêmement complexe. Le procédé systématique de fonctions de transfert des correcteurs sera présenté dans le cas d'une PLL à deux degrés de liberté, mais peut être aisément généralisé.

Une introduction générale à la méthode $H_\infty$ et à l'utilisation de fonctions de pondération dans le cadre de cette méthode - ce qui constitue un aspect important de l'invention - peut être trouvée dans le document suivant : [Bib-1992], [ScF-2009] et [SkP-2005].

En plus de garantir des performances prédéfinies en termes de rejet du bruit de phase, les correcteurs doivent avantageusement assurer que le signal de sortie φ suive le signal $\varphi_{ref}$ en entrée, et que donc le signal d'erreur ε tende vers zéro quand le temps tend vers l'infini. Conformément au théorème de la valeur finale en supposant que la PLL soit stable, les correcteurs doivent assurer :

$$\lim_{t \to +\infty} \varepsilon(t) = \lim_{s \to 0} s\varepsilon(s) = \lim_{s \to 0} sS(s)\varphi_{ref}(s) = 0 \qquad (3)$$

On considère le cas d'un signal de référence en forme de rampe de phase (le signal de tension $s_{ref}$ est donc une sinusoïde) ; sa transformée de Laplace est donc $\varphi_{ref}(s) = As^{-2}$, où A est la pente de la rampe. On obtient donc :

$$\lim_{p \to 0} sS(s)\varphi_{ref}(s) = \lim_{p \to 0} sS(s)As^{-2} = \lim_{s \to 0} As^{-1}S(s) = 0 \qquad (3')$$

d'où on déduit que la fonction de sensibilité doit présenter une pente d'au moins +40dB/déc pour des basses fréquences.

En variante, si seule une synchronisation en fréquence est demandée et pas en fréquence et en phase, on doit seulement assurer que ε tende vers une valeur constante, éventuellement différente de zéro. Dans ce cas, on peut relâcher la condition sur la pente de fonction de sensibilité à basse fréquence, qui doit seulement être supérieure ou égale à +40dB/déc.

En outre, on souhaite imposer que la DSP du bruit de phase en sortie (figure 7) respecte un « gabarit » imposé par le cahier des charges défini pas les frontières représentées par les hachures ; en d'autres termes, la DSP du bruit de phase de sortie doit se trouver au-dessous de ces frontières ; le gabarit n'étant pas défini pour toutes les fréquences, il est avantageusement remplacé par la fonction continue $L_\varphi(f)$.

Ces contraintes de sortie doivent être respectées en tenant compte des performances intrinsèques des composants au niveau du bruit de phase de l'oscillateur de référence, $L_{bref}(f)$ (figure 6a), et celui de l'oscillateur à fréquence contrôlée $L_b(f)$ (figure 6b), qui sont fournis par les spécifications techniques de ces composants.

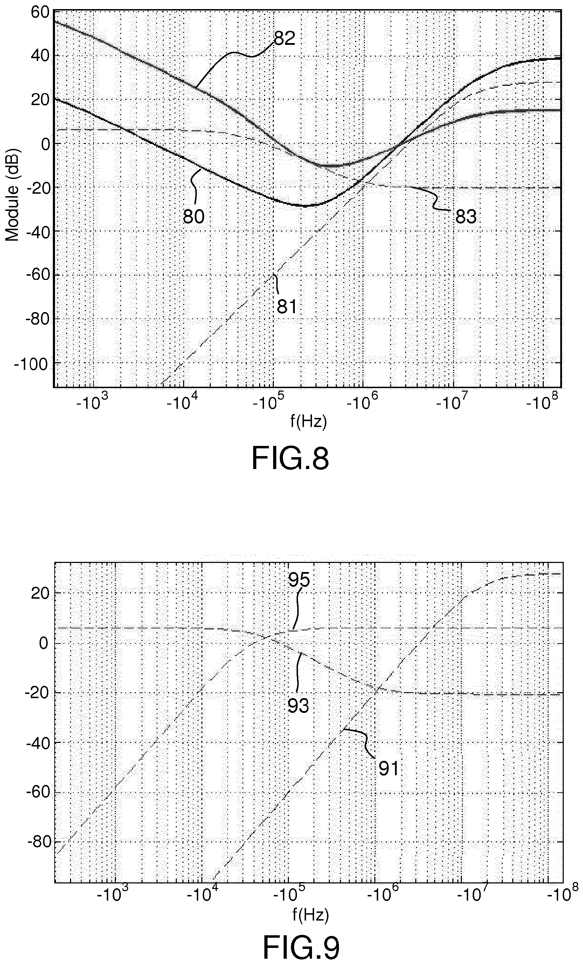

A partir des gabarits des DSP $L_\varphi(f)$, $L_{bref}(f)$ et $L_b(f)$, on détermine les gabarits pour les modules des réponses fréquentielles des deux fonctions de transfert, représentés par des lignes continues sur la figure 8 : $L_\varphi(f)/L_{bref}(f)$ - c'est-à-dire la contrainte sur $|S(j2\pi f)|$ (courbe 80) - et $L_\varphi(f)/L_b(f)$ - c'est-à-dire la contrainte sur $|T(j2\pi f)|$ (courbe 82).

Conformément à la méthode $H_\infty$, les contraintes sur les modules des réponses fréquentielles des fonctions de transfert $S(s)$ et $T(s)$ exprimées par ces gabarits sont modélisés par des fonctions de transfert dites « pondérations ». Dans le cas d'un système comme celui de l'invention, il existe deux sortes de pondérations : celles en entrée $W_i$ et celles en sortie $W_o$. Les pondérations peuvent être choisies comme étant des filtres blanchisseurs, auquel cas $W_i$ est l'inverse de la caractéristique de DSP en bruit d'entrée et $W_o$ est l'inverse de la caractéristique de DSP en bruit de sortie. Plus généralement, on considère le cas d'une fonction de transfert générique $H(s)$, dont le module au carré de la réponse fréquentielle doit respecter les contraintes imposées par les masques de DSP de bruit en entrée et en sortie $L_{in}(f)$ et $L_{out}(f)$. On écrit alors :

$$|H(j2\pi f)|^2 < (|W_o(j2\pi f)W_i(j2\pi f)|^{-1})^2 = L_{out}(f)/L_{in}(f)$$

d'où :

$$|W_o(j2\pi f)H(j2\pi f)W_i(j2\pi f)| < 1.$$

Dans le cas de la PLL de la figure 4a, on peut utiliser trois fonctions de pondération : deux en entrée ($W_b$ et $W_{bref}$) et une en sortie ($W_\varphi$), telles que : $|W_\varphi W_b|^{-1}$ approche la contrainte sur $|S(j2\pi f)|$ et $|W_\varphi W_{bref}|^{-1}$ approche la contrainte sur $|T(j2\pi f)|$. En réalité, comme les contraintes présentent une forme complexe, cette approche conduirait à des contrôleurs d'ordre élevé. Il est donc préférable de remplacer les contraintes d'origine (lignes continues sur la figure 8), obtenues à partir du cahier des charges (figure 7) et des spécifications techniques des composants (figures 6a et 6b), par des contraintes simplifiées, plus fortes (inférieures aux contraintes d'origine à toutes les fréquences), présentant un nombre limité (un ou deux, voire trois mais de préférence pas davantage) de changements de pente et des pentes asymptotiques de $\pm 20$ dB/déc ou de $\pm 40$ dB/déc, voire de $\pm 60$ dB/déc et de préférence pas davantage.

Des contraintes simplifiées sont illustrées en traits pointillés sur la figure 8. On remarque que la contrainte simplifiée 81 sur $L_\varphi(f)/L_b(f)$ - et donc sur la fonction de sensibilité $S(s)$ - présente une pente de +40 dB/decade entre $10^2$ et $10^6$ Hz, de façon à assurer que l'erreur de phase $\varepsilon$ tende à zéro en régime permanent (au-dessous de $10^2$ Hz la pente du module de la réponse fréquentielle de la fonction de sensibilité n'a plus d'importance car ce module est extrêmement petit, de l'ordre de -100 dB). La courbe 83 représente la contrainte simplifiée sur $|T(j2\pi f)|$. On remarque aussi que les fréquences de coupure pour l'atténuation des deux types de bruit (atténuation supérieure à 6dB simultanément pour les deux fonctions) se trouvent distantes de plus de deux décades ($10^7$ Hz pour le bruit du VCO, moins de $10^5$ Hz pour le bruit de la référence), alors qu'elles sont proches ou coïncidentes dans le cas d'une architecture à 1 degré de liberté.

En variante, il est possible d'utiliser l'erreur de phase $\varepsilon$ pour imposer les contraintes de performance sur le bruit de phase. Cela conduit à contraindre la DSP de l'erreur $\varepsilon$ par rapport à celle de deux signaux du bruit (référence et VCO) en utilisant une contrainte équivalente sur $L_\varepsilon/L_{bref}$ (la contrainte sur $L_\varepsilon/L_b$ est la même que celle sur $L_\varphi L_b$). Dans ce cas également il conviendra de simplifier les contraintes. La figure 9 illustre les contraintes simplifiées sur $L_\varphi L_b = L_\varepsilon/L_b$ (91), sur $L_\varphi/L_{bref}$ (93) et sur $L_\varepsilon/L_{bref}$ (95).

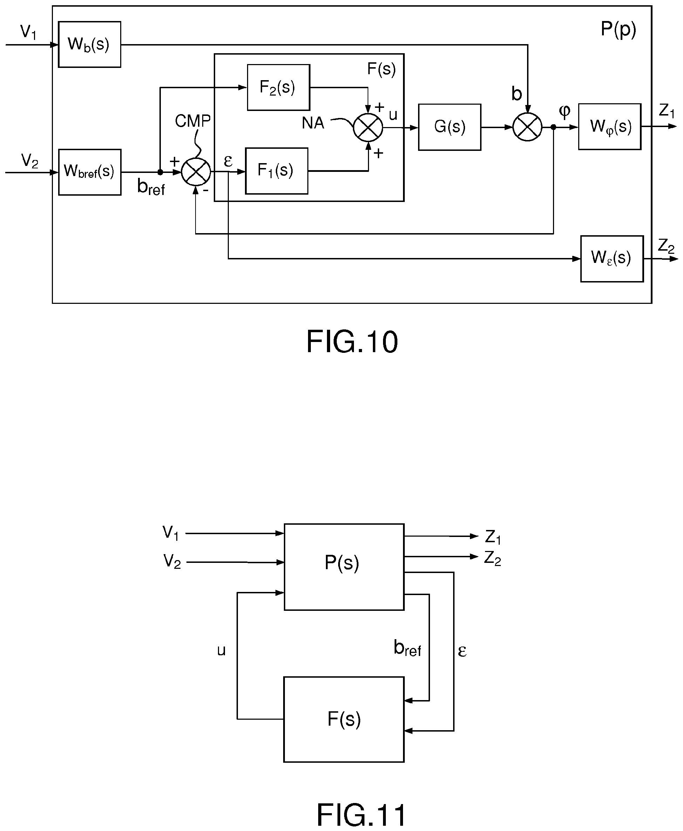

La figure 10 illustre le système « augmenté » constitué par la boucle de verrouillage de phase de la figure 4a et ses fonctions de pondération en entrée, $W_b(s)$ et $W_{bref}(s)$ et en sortie $W_\varphi(s)$ et $W_\varepsilon(s)$. En réalité, une seule de ces deux pondérations en sortie (au choix) est utilisée pour la synthèse des correcteurs (la forme des fonctions de pondération en entrée dépend de ce choix). On peut distinguer deux parties constitutives de ce système augmenté : le correcteur (vectoriel) $\mathbf{F}(s)$, comprenant les deux correcteurs $F_1$ et $F_2$ à synthétiser et le noeud additionneur combinant leur sorties pour générer le signal d'asservissement u, et une partie dite « Procédé augmenté» (« *augmented plant* » an anglais) $\mathbf{P}(s)$, comprenant tous les autres éléments. Les signaux d'entrée $v_1$ et $v_2$ (qui sont transformés en les bruits b et $b_{ref}$) et de sortie $z_1$ et $z_2$ (obtenus par pondération de $\varphi$ et de $\varepsilon$, respectivement) sont, par construction des fonctions de pondération, des bruits blancs. La figure 11 montre une représentation condensée du système augmenté.

La fonction de transfert $\mathbf{P}(s)$ est donnée, car elle dépend de la topologie de la PLL et de $G(s)$, ainsi que des pondérations qui ont été déterminées de manière à satisfaire les contraintes sur le bruit de phase. La fonction de transfert $\mathbf{F}(s)$ est synthétisée, conformément à la méthode $H_\infty$, de manière à satisfaire la condition

$$\|\mathbf{P}(s) \star \mathbf{F}(s)\|_{\infty} < 1 \qquad (4)$$

où l'opérateur « $\star$ » indique le produit de Redheffer et $\|\cdot\|_{\infty}$ indique la norme $H_{\infty}$. La recherche d'une fonction de transfert vectorielle $\mathbf{F}(s)$ satisfaisant l'inégalité (4) est un problème classique qui peut être résolu, à l'aide d'un ordinateur, par des algorithmes de calcul numérique bien connus de l'art antérieur ; voir par exemple [ScF-2009].

Conformément à l'invention, la synthèse des correcteurs peut être soumise à d'autres contraintes, par exemple :

- stabilité robuste, qui impose $|S(j2\pi f)|_{dB} < 6$ dB $\forall f$ ;
- limitation de la DSP du signal d'asservissement, ou de commande, u(t).

Pour le choix des pondérations permettant de satisfaire ces contraintes on pourra se référer à [ScF-2009].

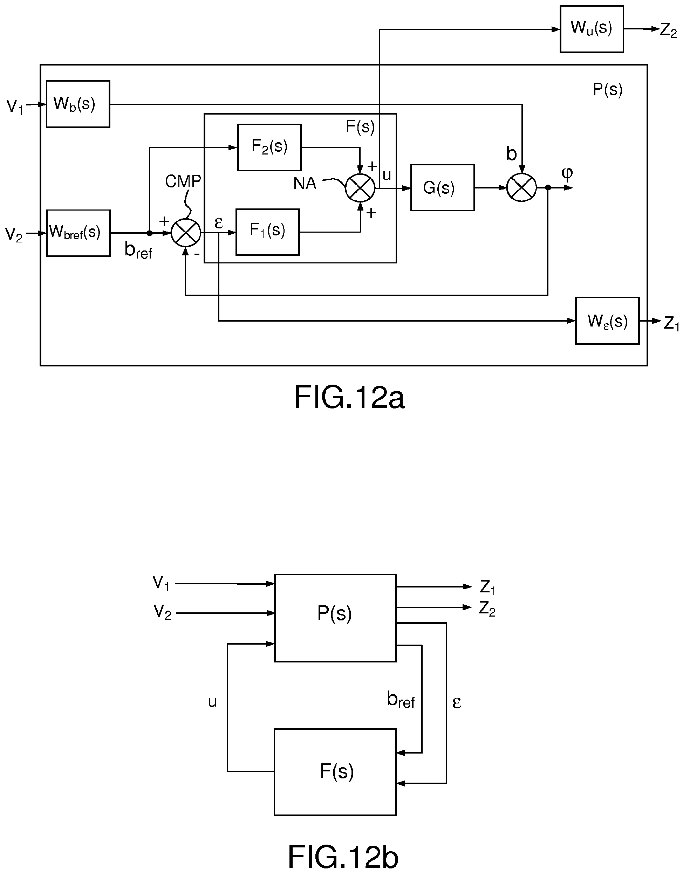

Les figures 12a et 12b illustrent, en représentation complète et condensée respectivement, le système augmenté obtenu si on souhaite respecter à la fois un gabarit de bruit de phase en sortie (ce qui est obtenu en utilisant l'erreur de phase $\varepsilon$) et un gabarit de DSP du signal d'asservissement u.

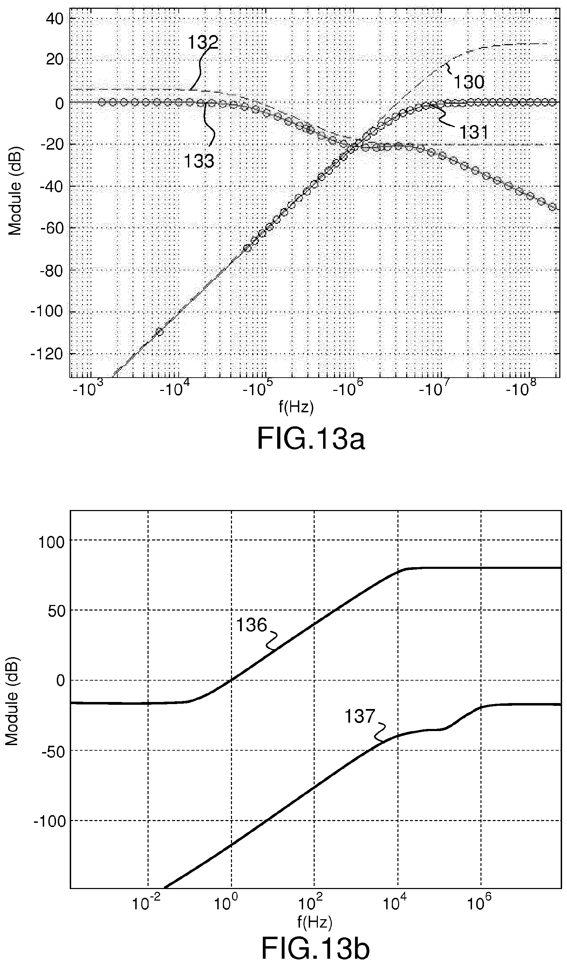

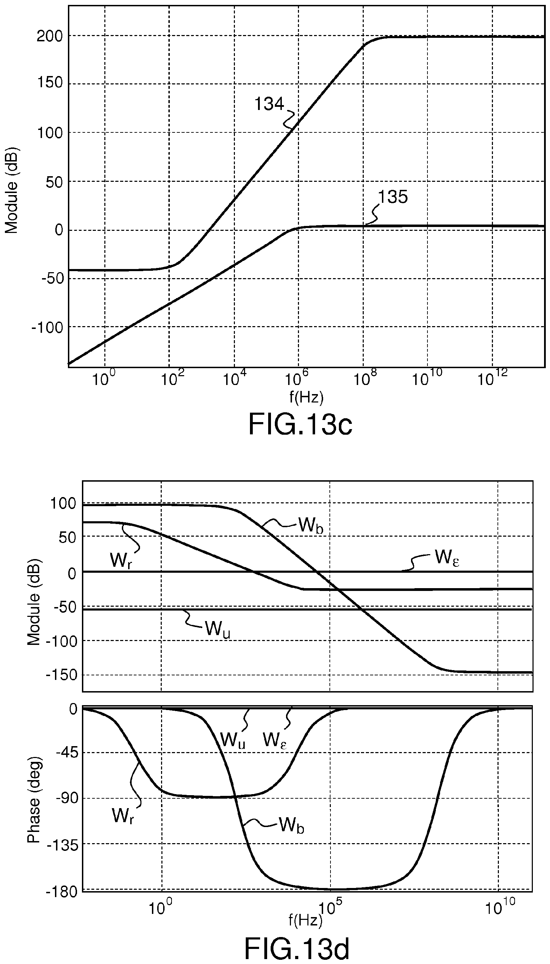

Sur la figure 13a, la courbe 130 représente la contrainte simplifiée d'atténuation du bruit du VCO ($L_{\varphi}/L_b$), la courbe 131 le module de la réponse fréquentielle de la fonction de sensibilité complémentaire effectivement obtenue, $|T(j2\pi f)|$, la courbe 132 la contrainte simplifiée d'atténuation du bruit de la référence ($L_{\varphi}/L_{bref}$) et la courbe 133 le module de la réponse fréquentielle de la fonction de sensibilité effectivement obtenue, $|S(j2\pi f)|$. On remarque que les contraintes sont respectées (la courbe 131 et 133 sont au-dessous des contraintes respectives 130 et 132). En outre, la valeur maximale de la contrainte 130 ne dépasse pas 6 dB, ce qui implique une stabilité robuste. Sur la figure 13b, la courbe 134 représente une contrainte sur la relation entre le bruit de la référence et le signal de commande u, et la courbe 135 le module de la réponse fréquentielle de la fonction de transfert entre bref et u effectivement obtenue. De façon similaire, sur la figure 13c, la courbe 136 représente une contrainte sur la relation entre le bruit du VCO et le signal de commande u, et la courbe 137 le module de la réponse fréquentielle de la fonction de transfert entre b et u effectivement obtenue

En appliquant cette méthode de synthèse des correcteurs à un cas particulier de cahier des charges et pour la topologie de la figure 4a, on parvient aux pondérations suivantes :

$$W_{bref}(s) = \frac{0{,}04\,s + 3350}{s + 1} \qquad (5)$$

$$W_b(s) = \frac{6 \cdot 10^{-14} s^2 + 1{,}2 \cdot 10^{-4} s + 6 \cdot 10^4}{10^{-6} s^2 + 2 \cdot 10^{-3} s + 1} \qquad (6)$$

$$W_u(s) = 2 \cdot 10^{-3} \qquad (7)$$

$$W_{\varepsilon}(s) = 1 \qquad (8)$$

Les diagrammes de Bode correspondants sont représentés sur la figure 13d (panneau supérieur : module ; panneau inférieur : phase).

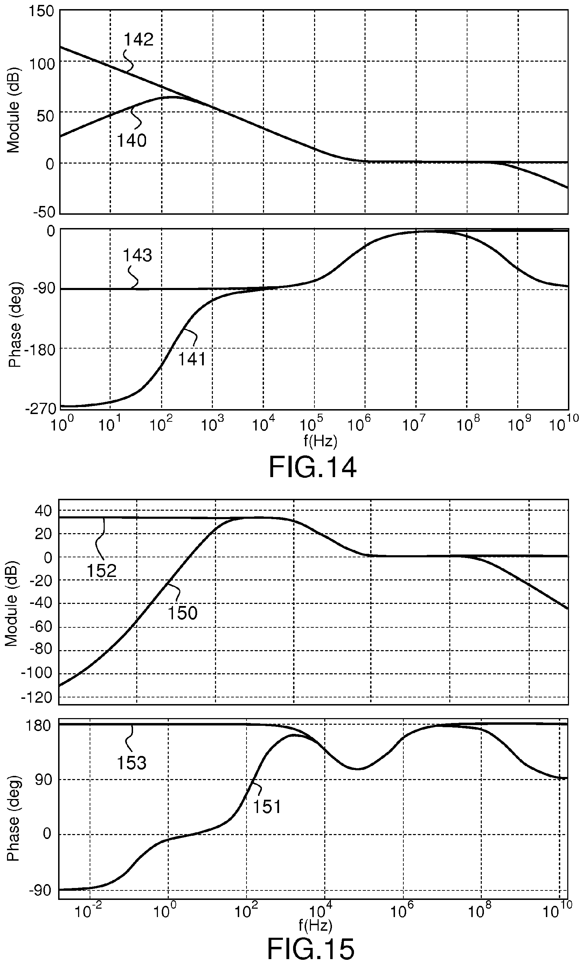

Bien que ces pondérations présentent un ordre non supérieur à 2 (elles correspondent à des contraintes simplifiées), elles conduisent néanmoins à des fonctions de transfert des correcteurs d'ordre important ; les courbes 140 et 141 sur la figure 14 montrent respectivement le module et la phase de $F_1(s)$, les courbes 150 et 151 sur la figure 15 montrent respectivement le module et la phase de $F_2(s)$. Ces fonctions de transfert peuvent être simplifiées en supprimant les pôles et zéros se trouvant à l'extérieur de la bande de fréquence d'intérêt. On obtient ainsi les fonctions de transfert suivantes, dont les modules et les phases sont également représentées sur les figures 14 et 15 (courbe 142 : module de $F_1$ après simplification ; courbe 143 : phase de $F_1$ après simplification ; courbe 152 : module de $F_2$ après simplification ; courbe 153 : phase de $F_2$ après simplification).

Les fonctions de transfert des correcteurs simplifiés sont :

$$F_1(s) = \frac{-1,41\,s + 1723 \cdot 10^6}{s + 6732 \cdot 10^4}$$

$$F_2(s) = \frac{1,5538\,s + 1658 \cdot 10^6}{s}$$

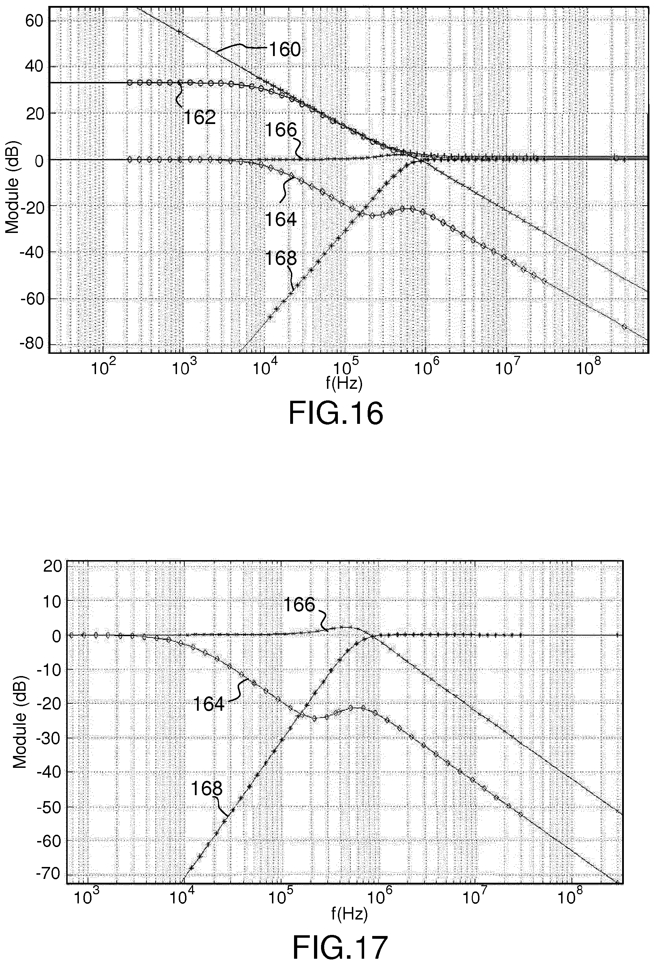

La figure 16 représente les diagrammes de Bode des amplitudes $F_1$ (courbe 160), de $F_2$ (courbe 162), du bruit de la référence mis en forme par les correcteurs de la PLL à deux degrés de liberté (courbe 164) et du bruit de la référence mis en forme par le correcteur unique d'une PLL à un degré de liberté dimensionnée de manière conventionnelle de façon à rejeter le bruit de référence (courbe 166), ainsi que le bruit du VCO mis en forme par le correcteur $F_1$ de la PLL à deux degrés de liberté ou par le correcteur unique de la PLL à un degré de liberté (courbe 168 - pour le bruit du VCO, il n'y a pas de différence .

Les courbes 164, 166 et 168 sont également reproduites agrandies sur la figure 17 pour plus de clarté.

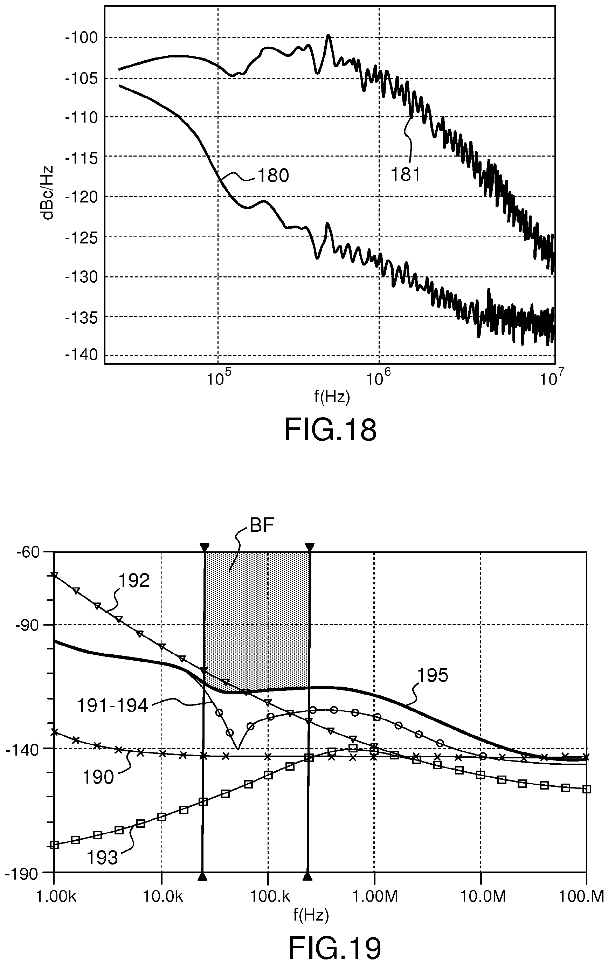

La figure 18 illustre la densité spectrale de puissance du bruit de phase de sortie de la PLL à deux degrés de liberté selon l'invention (courbe 180) comparé à celui d'une PLL à un degré de liberté selon l'art antérieur. Les DSP des bruits ont été estimées par la méthode de Welch et sont exprimées en dBc, par rapport à la puissance d'une raie spectrale idéale, sans bruit.

La figure 19 présente, à titre d'illustration, les résultats de simulation électrique des performances d'une PLL à deux degrés de liberté présentant les deux correcteurs ainsi synthétisés. Les courbes représentent les bruits de phase de la référence et du VCO en sortie de PLL en boucle ouverte ou fermée ainsi que leur contributions additionnées comparées aux contributions en bruit de l'ensemble de la PLL (courbe 190 : bruit de phase de la référence en sortie en boucle ouverte ; courbe 191 : bruit de phase de la référence en sortie en boucle fermée ; courbe 192 : bruit de phase du VCO en sortie en boucle ouverte ; courbe 193 : bruit de phase du VCO en sortie en boucle fermée ; courbe 194, pratiquement coïncidente avec 191 : somme des contributions de la référence et du VCO ; courbe 195 : bruit de phase total en sortie). La bande de fonctionnement de la PLL, BF, s'étend entre 25 et 250 kHZ environ ; le bruit de phase total est approximativement constant à l'intérieur de cette bande, compris entre -113 et -115 dB.

Une fois les correcteurs synthétisés par la méthode décrite ci-dessus, la conception de la PLL peut être finalisée, puis la PLL peut être réalisée en forme intégrée ou discrète par des techniques conventionnelles de l'électronique.

Comme cela a été mentionné plus haut, il est difficile de mesurer directement le signal de bruit de phase de la référence ou de sortie de la PLL qui doit être fourni en entrée du correcteur $F_2(s)$. Pour cette raison, il est avantageusement prévu d'utiliser un circuit estimateur, adapté pour recevoir en entrée un signal de tension (signal de référence, ou signal de sortie de la PLL) et pour fournir au correcteur $F_2(s)$ une estimation du bruit de phase affectant ce signal (voir les figures 4b et 5b). La figure 20 montre un schéma fonctionnel d'un tel circuit, recevant en entrée un signal périodique V(t) et comportant :

- une première branche comprenant un module retardateur, introduisant un retard $T_d$ du signal V(t);
- une deuxième branche, connectée en parallèle à la première branche et comprenant un module déphaseur, introduisant un déphasage $\delta\varphi$ du signal V(t), avec

$$\delta\varphi - \omega_{ref}T_d = \frac{\pi}{2} + 2\pi k, k \in Z , \qquad (9)$$

où $\omega_{ref}$ est la fréquence du signal périodique
- un mélangeur MIX configuré pour multiplier le signal retardé $V_{T_d}$ issu de la première branche et le signal déphasé $V_{\delta\varphi}$ issu de la deuxième branche ; et
- un filtre dit « rejeteur » $F_{rej}(s)$, de type passe-bas recevant en entrée le signal de sortie $V_{mix}$ dudit mélangeur et fournissant à sa sortie un signal $V_{EXT}$ constituant l'estimation recherchée du bruit de phase affectant le signal d'entrée V.

Du point de vue formel, la démonstration suivante présente le fonctionnement de l'estimateur de bruit de phase.

On considère que le signal d'entrée V(t) est une sinusoïde de pulsation $\omega_{ref}$ affectée par un bruit de phase $b_{ref}(t)$ :

$$V(t) = A\sin(\omega_{ref}t + b_{ref}(t)) \tag{10}$$

On a alors :

$$V_{Td}(t) = A\sin(\omega_{ref} \times (t - T_d) + b_{ref}(t - T_d)) \tag{11}$$

$$V_{\delta\varphi}(t) = A\sin(\omega_{ref}t + b_{ref}(t) - \delta\varphi) \tag{12}$$

Des calculs trigonométriques permettent de montrer que :

$$V_{mix}(t) = \frac{A^2}{2}[\cos(2\omega_{ref}t - \omega_{ref}T_d + b_{ref}(t - T_d) + b_{ref}(t) - \delta\varphi) + \\ + \cos(b_{ref}(t - T_d) - b_{ref}(t) + \delta\varphi - \omega_{ref}T_d)] \tag{13}$$

La composante de $V_{mix}$ à la pulsation $2\omega_{ref}$ est destinée à être filtrée par le filtre $F_{rej}$ ; en outre, la relation (9) permet de simplifier l'expression (13). On peut donc écrire

$$Vmix(t) = \frac{A^2}{2}\sin(b_{ref}(t - T_d) - b_{ref}(t)) + VmixHF(t) \approx \\ \approx \frac{A^2}{2}(b_{ref}(t - T_d) - b_{ref}(t)) + VmixHF(t) \tag{14}$$

où $V_{mixHF}(t)$ est la composante à haute fréquence de $V_{mix}$ qui est filtrée.
En représentation fréquentielle, et en négligeant la composante $V_{mixHF}(t)$, on peut écrire

$$V_{mix}(s) \approx \frac{A^2}{2}(1 - e^{-sT_d})b_{ref}(s) = H(s)b_{ref}(s) \tag{15}$$

Pour que le signal de sortie du circuit fournisse une image du bruit de phase, il faudrait que le filtre $F_{rej}$ inverse la fonction de transfert H(s) ; cela n'est pas possible car H(s) est non-causale, mais l'inversion peut être réalisée sur une bande limitée, ou H(s) peut être linéarisée :

$$H(s) \rightarrow H_{lin}(s) = T_d \cdot s \tag{16}$$

On peut donc prendre

$$F_{rej} = \frac{K}{\tau s + 1} \tag{17}.$$

où K est un gain à basse fréquence et $\tau$ une constante de temps. Le filtre rejeteur est donc un filtre passe-bas, ce qu'on avait admis en précédence.
En variante, H(s) peut être intégrée au procédé augmenté P(s) ; dans ce cas, elle est prise en compte lors de la synthèse des correcteurs. En d'autres termes, le filtre $F_{rej}$ peut être « intégré » à l'un des correcteurs de la PLL, auquel cas le circuit d'estimation du bruit de phase peut ne comporter que le module retardateur Td, le module déphaseur $\delta\varphi$ et le mélangeur MIX.
La réalisation matérielle des modules de retard et déphaseur peut dépendre de la topologie de PLL considérée (v. infra).
La figure 21 montre le schéma de principe d'une PLL à deux degrés de liberté en modalité commande par anticipation avec estimation du bruit de la référence, du type de la figure 4b. Dans cette configuration, le circuit estimateur de bruit reçoit en entrée le signal de référence, qui est ici généré par un oscillateur à quartz OREF. Le chemin de rétroaction de la boucle comprend un diviseur de fréquence DIV ; ainsi, le signal de sortie de la PLL présente une fréquence multiple de celle du signal de référence. Le déphasage et le retard peuvent être introduits par des amplificateurs chargés par des lignes RC et suivis par des circuits comparateurs de tension, en tenant compte du fait qu'un retard est représenté par un déphasage qui varie linéairement avec la fréquence.

Le filtre $F_{rej}$ et les correcteurs $F_1$ et $F_2$ peuvent être réalisés, par exemple, sous la forme de correcteurs PID (Proportionnel - Intégral - Dérivée) à amplificateurs opérationnels, comme illustré sur la figure 22.

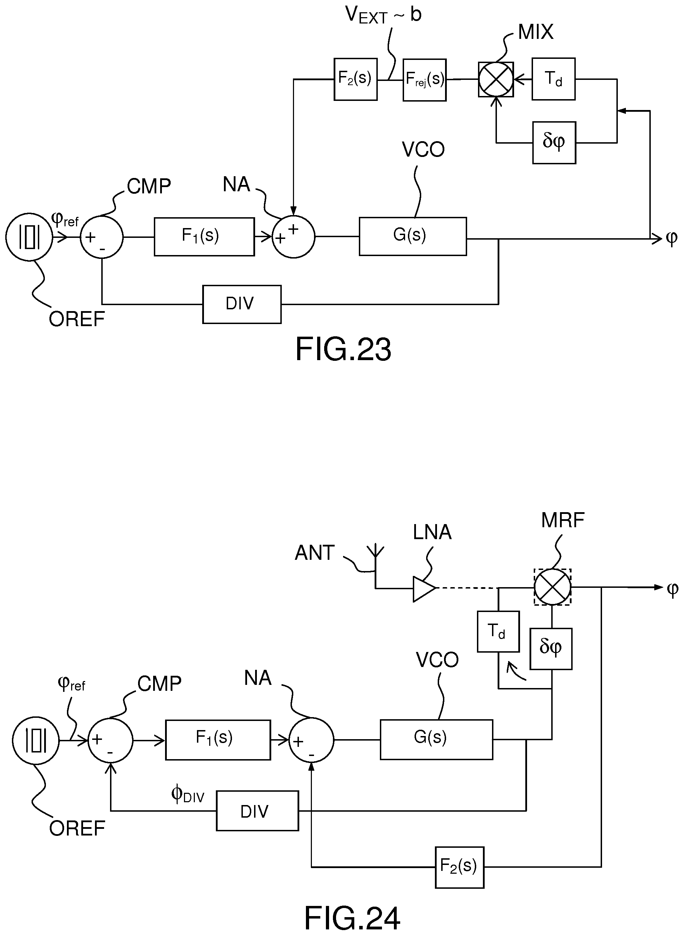

La figure 23 montre le schéma de principe d'une PLL à deux degrés de liberté en modalité de rétroaction avec estimation du bruit du VCO, du type de la figure 5b. Cette configuration, dans laquelle le circuit estimateur de bruit est agencé en aval du VCO, simplifier la réalisation des modules de retard et de déphasage. Ainsi, le déphasage $\delta\varphi$ peut être réalisé en utilisant un VCO en quadrature (QVCO) bien connu de l'homme de l'art si $\delta\varphi = \pi/2$ ; Plus généralement, un filtre polyphasé peut permettre de générer un déphasage arbitraire$\delta\varphi$. Il est également possible d'utiliser un système d'oscillateurs couplés. En contrôlant le taux de couplage des oscillateurs il est ainsi possible de régler l'avance ou le retard de l'un par rapport à l'autre et de générer un déphasage contrôlé. Le retard Td peut être réalisé de manière numérique dans le cas d'oscillateur VCO en anneau (« ring oscillator »). Dans le cas de signaux sinusoïdaux, le retard $T_d$ peut être introduit par une ligne de propagation LC ou équivalent, par exemple une ligne de propagation à onde lente. Une solution sous-optimale alternative consiste à remplacer le retard $T_d$ par un déphasage $\delta\varphi_R = \omega_{VCO} \cdot T_d$ où $\omega_{VCO}$ est la pulsation du VCO en régime établi. La solution est sous-optimale dans la mesure où le retard équivalent ainsi généré n'est pas constant sur l'ensemble des fréquences autour de $\omega_{VCO}$.

Enfin le mélangeur peut être réalisé par des portes logiques de type NOR ou XNOR ou une cellule de Gilbert.

La figure 25 montre le schéma de principe d'une PLL à trois degrés de liberté combinant commande par anticipation (correcteur $F_2$) et rétroaction (correcteur $F'_2$) avec estimation du bruit de la référence et du bruit du VCO. Les modules de retard, déphasage, le mélangeur et le filtre rejeteur de l'estimateur de phase utilisé pour estimer le bruit du VCO sont identifiés par les références $T_d'$, $\delta\varphi'$, MIX' et $F_{rej}'$ pour les distinguer des éléments correspondants de l'estimateur de phase de la référence.

La figure 24 montre le schéma de principe d'une chaine de réception radiofréquence utilisant une PLL à deux degrés de liberté utilisant une PLL du type de la 23 en tant qu'oscillateur local pour la conversion en bande de base, ou en fréquence intermédiaire, du signal a radiofréquence capté par une antenne ANT et préamplifié par un amplificateur à bas bruit LNA. Avantageusement, le mélangeur à radiofréquence MRF est utilisé en tant que mélangeur du circuit d'estimation du bruit, ce qui permet de faire l'économie d'un élément. L'oscillateur local oscille à la fréquence porteuse $f_0$ ; la sortie de cet oscillateur est multipliée, par le mélangeur, par une partie d'elle-même qui provient d'une « fuite » volontaire à travers le module de retard $T_d$ (représentée par une flèche sur la figure), ce qui engendre un signal à la fréquence $2f_0$, qui est filtré par le correcteur $F_2$, et un signal en bande de base, qui constitue le signal de rétroaction de la PLL. Le filtre passe-bas $F_{rej}$ n'est pas représenté sur le schéma de la figure 24 car il est intégré au correcteur $F_2$.

L'invention n'est pas limitée au cas d'une PLL analogique, mais peut concerner également une PLL numérique, et notamment une PLL entièrement numérique (ADPLL « All-Digital PLL ») tel que décrite dans les articles [STA-2004] et [STA-2005], comme illustré sur la figure 26.

Dans cette ADPLL, un oscillateur contrôlé numériquement DCO engendre un signal CKV qui doit être asservi en phase à un signal de référence de plus basse fréquence, FREF. Le rapport entre la fréquence du DCO et celle de la référence n'est pas nécessairement entier ; il est donc nécessaire de générer un signal de référence re-temporisé CKR, utilisé comme signal d'horloge. Ce signal CKR est obtenu en sur-échantillonnant FREF par le signal haute fréquence CKV à l'aide d'une bascule ECH1.

Un accumulateur APO compte les fronts montants (ou descendants) du signal CKV ; le signal de comptage ainsi obtenu, indiqué par $R_{vi}[i]$, est re-temporisé à la cadence du signal d'horloge CKR à l'aide d'une bascule ECH2 ; on indique par $R_V[k]$ le signal re-temporisé.

Le signal $R_R[k]$ est obtenu en accumulant, à l'aide d'un accumulateur APR, un mot binaire FCW égal au rapport entre les fréquences de CKV et FREF.

Le signal $\varepsilon[k]$ est obtenu à l'aide d'un convertisseur temps - numérique (« *Time-to-Digital Converter* ») TDC quantifiant le décalage temporel entre les fronts montants (ou descendants) des signaux FREF et CKV, dont la sortie est re-temporisée à la cadence du signal d'horloge CKR à l'aide d'une bascule ECH3.

Une estimation $\varphi_E[k]$ de l'erreur de phase entre FREF et CKV est donnée par :

$$\varphi_E[k] = R_R[k] - R_V[k] + \varepsilon[k] \qquad\qquad (18)$$

Il convient de préciser que, dans ce contexte, la « phase » d'un signal est donnée par le nombre de ses fronts montants (ou descendants), comptés à partir d'un instant initial.

**EP 2 996 249 B1**

Le signal d'erreur $\phi_E[k]$ est fourni en entrée à un premier correcteur de fonction de transfert $F_1(z)$. Conformément à l'invention, la ADPLL comprend également un deuxième correcteur en mode de commande par anticipation, $F_2(z)$, recevant en entrée le signal $\varepsilon[k]$, et/ou un troisième correcteur en mode de rétroaction, $F_3(z)$, recevant en entrée le signal $R_V[k]$. Comme dans une réalisation analogique, les signaux de contrôles générés par les correcteurs $F_1(z)$, $F_2(z)$ et/ou $F_3(z)$ sont combinés dans un noeud additionneur NA pour obtenir un signal (numérique) de pilotage de l'oscillateur DCO.

Références

[Bib-1992] Johen E. Bibel, Stephen Malyevac « Guidelines for the selection of weighting functions for H-infinity control », AD-A251 781 Naval Surface Warfare Center, Jan. 1992, URL: http://www.dtic.mil/dtic/tr/fulltext/u2/a251781.pdf.
[ScF-2009] Scorletti G. Fromion V. "Automatique fréquentielle avancée", polycopie de cours, Sciences de l'ingénieur, http://cel.archives-ouvertes.fr/cel-00423848.
[SkP-2005] S. Skogestad and I. Postlethwaite, "Multivariable Feedback Control, Analysis and Design", John Wiley and Sons Chischester, 2005.
[ChM-2007] W. Chaivipas, A. Matsuzawa, « Analysis and Design of Direct Reference Feed-Forward. Compensation for Fast-Settling All-Digital Phase-Locked Loop ». IEICE TRANS. ELECTRON., VOL.E90-C, NO.4 April 2007
[SNI-2012] B. Indu Rani, C.K. Aravind G. Saravana Ilango, C. Nagamani, « A three phase PLL with a dynamic feed forward frequency estimator for synchronization of grid connected converters under wide frequency variations ». Electrical Power and Energy Systems, 41:63-70, 2012.
[STA-2004] R.B.Staszewski et al., « All-Digital TX Frequency Synthesizer and Discrete-time Receiver for Bluetooth Radio in 130-nm CMOS », IEEE Journal of Solid-State Circuits, Vol.39, No.12, Déc.2004
[STA-2005] R.B.Staszewski, P.T. Balsara « Phase-Domain All-Digital Phase-Locked Loop », IEEE Transaction on Circuits and Systems - II: Express Briefs, Vol. 52, No. 3, Mars 2005.

**Revendications**

**1.** Procédé de conception d'une boucle à verrouillage de phase, du type comprenant ;

- un oscillateur à fréquence contrôlée (VCO, DCO) ;
- un comparateur de phase (CMP), configuré pour déterminer une différence de phase entre un signal de sortie dudit oscillateur à fréquence contrôlée et un signal de référence ;
- un correcteur ($F_1$), dit premier correcteur, configuré pour recevoir en entrée un signal représentatif de ladite différence de phase et pour générer à sa sortie un signal dit premier signal de correction ;
- au moins un autre correcteur ($F_2$), dit deuxième correcteur, configuré pour recevoir en entrée un signal représentatif de ou affecté par un bruit de phase dudit signal de référence ou dudit signal de sortie dudit oscillateur à fréquence contrôlée et pour générer à sa sortie un signal dit deuxième signal de correction ; et
- un moyen (NA) de génération d'un signal d'asservissement (u) dudit oscillateur à fréquence contrôlée à partir desdits premier et deuxième signaux de correction ;

ledit procédé comprenant une étape de détermination de fonctions de transfert desdits correcteurs et étant **caractérisé en ce que** lesdits premier et deuxième correcteurs présentent des fonctions de transfert non constantes, choisies de manière à permettre le rejet, dans une même bande de fréquence, du bruit de phase dudit signal de référence et du bruit de phase dudit signal de sortie dudit oscillateur à fréquence contrôlée et **en ce que** ladite étape est mise en oeuvre, au moyen d'un ordinateur, par application de la méthode $H_\infty$ en utilisant :

- en entrée, une fonction de pondération ($W_b$) d'un bruit de phase dudit oscillateur à fréquence contrôlée, dite première fonction de pondération, et une fonction de pondération ($W_{bref}$) d'un bruit de phase d'un signal de référence, dite deuxième fonction de pondération, déterminées à partir de densités spectrales de puissance nominales desdits bruit ; et
- en sortie, au moins une fonction de pondération ($W_\phi$, $W_\varepsilon$) d'un bruit de phase d'un signal de sortie de la boucle de verrouillage de phase ou d'une erreur de suivi dudit signal de référence, dite troisième fonction de pondération, déterminée à partir d'un gabarit de densité spectrale de puissance de bruit de phase dudit signal de sortie devant être respecté.

**2.** Procédé selon la revendication 1 dans lequel ladite étape de détermination de fonctions de transfert desdits correcteurs comprend les sous-étapes suivantes :

a) déterminer une densité spectrale de puissance nominale dudit signal de référence ;
b) déterminer une densité spectrale de puissance nominale du bruit de phase dudit oscillateur à fréquence contrôlée ;
c) déterminer un gabarit de densité spectrale de puissance de bruit de phase dudit signal de sortie devant être respecté ;
d) à partir desdites densités spectrales de puissance nominale et dudit gabarit de densité spectrale de puissance, déterminer au moins lesdites première, deuxième et troisième fonctions de pondération ;
e) construire un système augmenté desdites pondération ; et
f) appliquer la méthode $H_\infty$ audit système augmenté pour synthétiser les fonctions de transfert desdits correcteurs.

**3.** Procédé selon la revendication 2 dans lequel ladite étape d) comprend également la détermination d'une fonction de pondération en sortie, dite quatrième fonction de pondération ($W_u$), de la densité spectrale de puissance dudit signal d'asservissement à partir d'un gabarit de densité spectrale de puissance dudit signal d'asservissement à respecter.

**4.** Procédé selon l'une des revendications 2 ou 3, comprenant également une sous-étape d') de simplification des fonctions de pondération déterminées lors de la sous-étape d), les fonctions de pondération ainsi simplifiées étant utilisées lors de ladite sous-étape e), ladite simplification étant mise en oeuvre en approchant lesdites fonctions de pondérations par des fonctions de transfert d'ordre plus faible et de module moins élevé au moins sur une plage spectrale de fonctionnement de la boucle à verrouillage de phase.

**5.** Procédé selon l'une des revendications 2 à 4 comprenant également une sous-étape g) de simplification des fonctions de transfert synthétisées lors de ladite sous-étape f), ladite simplification étant mise en oeuvre en approchant lesdites fonctions de transfert par des fonctions de transfert d'ordre plus faible.

**6.** Procédé selon l'une des revendications 2 à 5 dans lequel ladite étape f) est mise en oeuvre avec une contrainte additionnelle, selon laquelle le module de la fonction de transfert (S) entre ledit signal de sortie dudit oscillateur à fréquence contrôlée et ledit signal de référence présente, dans au moins une plage spectrale, une pente supérieure ou égale à +20 db/décade et de préférence à 40 dB/décade.

**7.** Procédé selon l'une des revendications précédentes, dans lequel ladite boucle à verrouillage de phase comprend au moins un autre correcteur ($F_3$), dit troisième correcteur, configuré pour recevoir en entrée un signal représentatif de ou affecté par un bruit de phase généré à l'intérieur de ladite boucle, autre que ledit bruit de phase dudit signal de sortie dudit oscillateur à fréquence contrôlée, et pour générer à sa sortie un signal dit troisième signal de correction, ledit moyen de génération d'un signal d'asservissement dudit oscillateur à fréquence contrôlée étant configuré pour générer ledit signal d'asservissement également à partir dudit troisième signal de correction. ladite étape de détermination de fonctions de transfert desdits correcteurs, mise en oeuvre par ladite méthode $H_\infty$, utilisant en entrée également une fonction de pondération dudit bruit de phase autre que ledit bruit de phase dudit signal de sortie dudit oscillateur à fréquence contrôlée, également déterminée à partir de la densité spectrale de puissance dudit bruit.

**8.** Procédé de fabrication d'une boucle à verrouillage de phase, du type comprenant ;

- un oscillateur à fréquence contrôlée (VCO) ;
- un comparateur de phase (CMP) pour déterminer une différence de phase entre un signal de sortie dudit oscillateur à fréquence contrôlée et un signal de référence ;
- un correcteur ($F_1$), dit premier correcteur, configuré pour recevoir en entrée un signal représentatif de ladite différence de phase et pour générer à sa sortie un signal dit premier signal de correction ;
- au moins un autre correcteur ($F_2$), dit deuxième correcteur, configuré pour recevoir en entrée un signal représentatif de ou affecté par un bruit de phase dudit signal de référence ou dudit signal de sortie dudit oscillateur à fréquence contrôlée et pour générer à sa sortie un signal dit deuxième signal de correction ; et
- un moyen (NA) de génération d'un signal ($s_u$, u) d'asservissement dudit oscillateur à fréquence contrôlée à partir desdits premier et deuxième signaux de correction ;

ledit procédé comprenant :

- une étape de conception de ladite boucle à verrouillage de phase ; et
- une étape de réalisation physique de la boucle à verrouillage de phase ainsi conçue ;

**caractérisé en ce que** ladite étape de conception est mise en oeuvre par un procédé selon l'une des revendications précédentes.

9. Procédé selon la revendication 8, dans lequel ladite boucle à verrouillage de phase comprend au moins un autre correcteur ($F_3$), dit troisième correcteur, configuré pour recevoir en entrée un signal représentatif de ou affecté par un bruit de phase généré à l'intérieur de ladite boucle, autre que ledit bruit de phase dudit signal de sortie dudit oscillateur à fréquence contrôlée, et pour générer à sa sortie un signal dit troisième signal de correction, ledit moyen de génération d'un signal d'asservissement dudit oscillateur à fréquence contrôlée étant configuré pour générer ledit signal d'asservissement également à partir dudit troisième signal de correction. ladite étape de conception étant mise en oeuvre par un procédé selon la revendication 7.

10. Boucle à verrouillage de phase comprenant :

- un oscillateur à fréquence contrôlée (VCO) adapté pour générer un signal de sortie présentant un bruit de phase ;
- un comparateur de phase (CMP) pour déterminer une différence de phase entre un signal de sortie dudit oscillateur à fréquence contrôlée et un signal de référence, ledit signal de référence présentant un bruit de phase ;
- un correcteur ($F_1$), dit premier correcteur, configuré pour recevoir en entrée un signal représentatif de ladite différence de phase et pour générer à sa sortie un signal dit premier signal de correction ;
- au moins un autre correcteur ($F_2$), dit deuxième correcteur, configuré pour recevoir en entrée un signal représentatif de ou affecté par le bruit de phase dudit signal de référence ou dudit signal de sortie dudit oscillateur à fréquence contrôlée et pour générer à sa sortie un signal dit deuxième signal de correction ; et
- un moyen (NA) de génération d'un signal ($s_u$, u) d'asservissement dudit oscillateur à fréquence contrôlée à partir desdits premier et deuxième signaux de correction ;

**caractérisée en ce que** lesdits premier et deuxième correcteur présentent des fonctions de transfert non constantes, choisies de manière à permettre le rejet, dans une même bande de fréquence, du bruit de phase dudit signal de référence et du bruit de phase dudit signal de sortie dudit oscillateur à fréquence contrôlée et obtenues par application de la méthode $H_\infty$ en utilisant :

- en entrée, une fonction de pondération ($W_b$) du bruit de phase dudit oscillateur à fréquence contrôlée, dite première fonction de pondération, et une fonction de pondération ($W_{bref}$) du bruit de phase dudit signal de référence, dite deuxième fonction de pondération, déterminées à partir de densités spectrales de puissance nominales desdits bruit ; et
- en sortie, au moins une fonction de pondération ($W_\varphi$, $W_\varepsilon$) d'un bruit de phase d'un signal de sortie de la boucle de verrouillage de phase ou d'une erreur de suivi dudit signal de référence, dite troisième fonction de pondération, déterminée à partir d'un gabarit de densité spectrale de puissance de bruit de phase dudit signal de sortie devant être respecté.

11. Boucle à verrouillage de phase selon la revendication 10 dans lequel ledit deuxième correcteur est configuré pour recevoir en entrée :

- soit un signal représentatif de la phase dudit signal de référence ;
- soit une estimation du bruit de phase dudit signal de référence.

12. Boucle à verrouillage de phase selon la revendication 11 comprenant également un circuit de détermination d'une estimation du bruit de phase dudit signal de référence comprenant :

- un module retardateur, configuré pour générer une version retardée d'un temps $T_d$ dudit signal de référence ;
- un module déphaseur, configuré pour générer une version dudit signal de référence présentant un déphasage $\delta\varphi$, avec
$$\delta\varphi - \omega_{ref} T_d = \frac{\pi}{2} + 2\pi k,$$
$k \in Z$, où $\omega_{ref}$ est la fréquence dudit signal de référence ; et
- un mélangeur (MIX) configuré pour recevoir en entrée les signaux de sortie desdits modules retardateur et déphaseur et pour fournir à sa sortie leur produit ;

ledit deuxième correcteur étant configuré pour recevoir en entrée ladite estimation du bruit de phase dudit signal de référence.

**13.** Boucle à verrouillage de phase selon la revendication 10 dans lequel ledit deuxième correcteur est configuré pour recevoir en entrée :

- soit un signal représentatif de la phase dudit signal de sortie dudit oscillateur à fréquence contrôlée ;
- soit une estimation du bruit de phase dudit signal de sortie dudit oscillateur à fréquence contrôlée.

**14.** Boucle à verrouillage de phase selon la revendication 13 comprenant également un circuit de détermination d'une estimation du bruit de phase dudit signal de sortie comprenant :

- un module retardateur, configuré pour générer une version retardée d'un temps $T_d$ dudit signal de sortie ;
- un module déphaseur, configuré pour générer une version dudit signal de sortie présentant un déphasage

$$\delta\varphi - \omega_o T_d = \frac{\pi}{2} + 2\pi k,$$

$\delta\varphi$, avec $k \in Z$, où $\omega_o$ est la fréquence dudit signal de sortie ; et

- un mélangeur configuré pour recevoir en entrée les signaux de sortie desdits modules retardateur et déphaseur et pour fournir à sa sortie leur produit ;

ledit deuxième correcteur étant configuré pour recevoir en entrée ladite estimation du bruit de phase dudit signal de sortie.

**15.** Boucle à verrouillage de phase selon l'une des revendications 10 à 14 comprenant également au moins un autre correcteur ($F_3$, $F_4$, $F_5$), dit troisième correcteur, configuré pour recevoir en entrée : un signal représentatif de ou affecté par un bruit de phase généré à l'intérieur de ladite boucle, autre que ledit bruit de phase dudit signal de sortie dudit oscillateur à fréquence contrôlée, et pour générer à sa sortie un signal dit troisième signal de correction, ledit moyen de génération d'un signal d'asservissement dudit oscillateur à fréquence contrôlée étant configuré pour générer ledit signal d'asservissement également à partir dudit troisième signal de correction.

**16.** Chaine de réception à radiofréquence comprenant :

- un préamplificateur à radiofréquence (LNA) ;
- un mélangeur (MRF) configuré pour recevoir en entrée un signal de sortie dudit préamplificateur à radiofréquence et un signal sinusoïdal de conversion de fréquence, et pour fournir en sortie un signal à fréquence intermédiaire ; et
- un circuit de génération dudit signal sinusoïdal de conversion de fréquence ;

dans laquelle ledit circuit de génération dudit signal sinusoïdal de conversion de fréquence comprend une boucle à verrouillage de phase selon la revendication 14, ou la revendication 15 lorsqu'elle dépend de la revendication 14, utilisant ledit mélangeur en tant que mélangeur dudit circuit de détermination d'une estimation du bruit de phase dudit signal de sortie, et un oscillateur configuré pour générer ledit signal de référence.

**Patentansprüche**

**1.** Verfahren zum Auslegen einer Phasenregelschleife, vom Typ, der Folgendes umfasst;

- einen frequenzgesteuerten Oszillator (VCO, DCO);
- einen Phasenvergleicher (CMP), der konfiguriert ist, um eine Phasendifferenz zwischen einem Ausgangssignal des frequenzgesteuerten Oszillators und einem Referenzsignal zu bestimmen;
- einen Korrektor ($F_1$), der als erster Korrektor bezeichnet wird, der konfiguriert ist, um als Eingang ein Signal zu empfangen, das für die Phasendifferenz repräsentativ ist, und um an seinem Ausgang ein Signal zu erzeugen, das als das erste Korrektursignal bezeichnet wird;
- mindestens einen weiteren Korrektor ($F_2$), der als der zweite Korrektor bezeichnet wird, der konfiguriert ist, um als Eingang ein Signal zu empfangen, das das Phasenrauschen des Referenzsignals oder des Ausgangssignals des frequenzgesteuerten Oszillators darstellt oder von diesem beeinflusst wird, und um an seinem Ausgang ein Signal zu erzeugen, das als das zweite Korrektursignal bezeichnet wird; und

- ein Mittel (NA) zum Erzeugen eines Regelungssignals (u) des frequenzgesteuerten Oszillators anhand des ersten und zweiten Korrektursignals;

wobei das Verfahren einen Schritt zum Bestimmen von Übertragungsfunktionen der Korrektoren umfasst und **dadurch gekennzeichnet ist, dass** der erste und der zweite Korrektor nicht-konstante Übertragungsfunktionen aufweisen, die so ausgewählt sind, dass sie die Ablehnung des Phasenrauschens des Referenzsignals und des Phasenrauschens des Ausgangssignals des frequenzgesteuerten Oszillators in einem gleichen Frequenzband ermöglichen, und dass der Schritt mittels eines Computers durch Anwendung des Verfahrens $H_{\infty}$ unter Verwendung von Folgendem implementiert wird:

- am Eingang, einer Gewichtungsfunktion ($W_b$) eines Phasenrauschens des frequenzgesteuerten Oszillators, die als erste Gewichtungsfunktion bezeichnet wird, und einer Gewichtungsfunktion ($W_{bref}$) eines Phasenrauschens eines Referenzsignals, die als zweite Gewichtungsfunktion bezeichnet wird, die anhand spektraler Nennleistungsdichten des Rauschens bestimmt werden; und
- am Ausgang, mindestens einer Gewichtungsfunktion ($W_{\varphi}, W_{\varepsilon}$) eines Phasenrauschens eines Ausgangssignals der Phasenregelschleife oder eines Verfolgungsfehlers des Referenzsignals, die als dritte Gewichtungsfunktion bezeichnet wird, die anhand eines Spektraldichteprofils der Phasenrauschleistung des einzuhaltenden Ausgangssignals bestimmt wird.

2. Verfahren nach Anspruch 1, wobei der Schritt zum Bestimmen der Übertragungsfunktionen der Korrektoren die folgenden Teilschritte umfasst:

   a) Bestimmen einer spektralen Nennleistungsdichte des Referenzsignals;
   b) Bestimmen einer spektralen Nennleistungsdichte des Phasenrauschens des frequenzgesteuerten Oszillators;
   c) Bestimmen eines Spektraldichteprofils der Phasenrauschleistung des einzuhaltenden Ausgangssignals;
   d) anhand der nominalen Leistungsspektraldichten und des Leistungsspektraldichteprofils, Bestimmen mindestens der ersten, zweiten und dritten Gewichtungsfunktion;
   e) Aufbauen eines erweiterten Systems der Gewichtungen; und
   f) Anwenden des Verfahrens $H_{\infty}$ auf das erweiterte System, um die Übertragungsfunktionen der Korrektoren zu synthetisieren.

3. Verfahren nach Anspruch 2, wobei der Schritt d) auch das Bestimmen einer Ausgangsgewichtungsfunktion, die als die vierte Gewichtungsfunktion ($W_u$) bezeichnet wird, der Leistungsspektraldichte des Regelungssignals anhand eines Leistungsspektraldichteprofils des einzuhaltenden Regelungssignals umfasst.

4. Verfahren nach einem der Ansprüche 2 oder 3, das auch einen Teilschritt d') zur Vereinfachung der in Teilschritt d) bestimmten Gewichtungsfunktionen umfasst, wobei die so vereinfachten Gewichtungsfunktionen in dem Teilschritt e) verwendet werden, wobei die Vereinfachung durch Annäherung von Übertragungsfunktionen niedrigerer Ordnung und weniger hoher Modulfunktionen an die Gewichtungsfunktionen zumindest über einen spektralen Betriebsbereich der Phasenregelschleife implementiert wird.

5. Verfahren nach einem der Ansprüche 2 bis 4, das auch einen Teilschritt g) zur Vereinfachung der in dem Teilschritt f) synthetisierten Übertragungsfunktionen umfasst, wobei die Vereinfachung durch Annäherung von Übertragungsfunktionen niedrigerer Ordnung an die Übertragungsfunktionen implementiert wird.

6. Verfahren nach einem der Ansprüche 2 bis 5, wobei der Schritt f) mit einer zusätzlichen Einschränkung implementiert wird, gemäß der das Modul der Übertragungsfunktion (S) zwischen dem Ausgangssignal des frequenzgesteuerten Oszillators und dem Referenzsignal in mindestens einem Spektralbereich eine Steigung größer als oder gleich +20 db/Dekade und vorzugsweise 40 dB/Dekade aufweist.

7. Verfahren nach einem der vorherigen Ansprüche, wobei die Phasenregelschleife mindestens einen weiteren Korrektor ($F_3$) umfasst, der als dritter Korrektor bezeichnet wird, der konfiguriert ist, um als Eingang ein Signal zu empfangen, das für das innerhalb der Schleife erzeugte Phasenrauschen repräsentativ oder von diesem beeinflusst ist, das sich von dem Phasenrauschen des Ausgangssignals des frequenzgesteuerten Oszillators unterscheidet, und um an seinem Ausgang ein Signal zu erzeugen, das als drittes Korrektursignal bezeichnet wird, wobei das Mittel zum Erzeugen eines Regelungssignals des frequenzgesteuerten Oszillators konfiguriert ist, um das Regelungssignal auch anhand des dritten Korrektursignals zu erzeugen, wobei der Schritt des Bestimmens von Übertragungsfunktionen der Korrektoren, die durch das Verfahren $H_\infty$, implementiert sind, als Eingang auch eine Gewichtungsfunktion des Phasenrauschens verwendet, das sich von dem Phasenrauschen des Ausgangssignals des frequenzgesteuerten Oszillators unterscheidet und auch anhand der Leistungsspektraldichte des Rauschens bestimmt wird.

8. Verfahren zur Herstellung einer Phasenregelschleife, vom Typ, der Folgendes umfasst;

   - einen frequenzgesteuerten Oszillator (VCO);
   - einen Phasenvergleicher (CMP) zum Bestimmen einer Phasendifferenz zwischen einem Ausgangssignal des frequenzgesteuerten Oszillators und einem Referenzsignal;
   - einen Korrektor ($F_1$), der als erster Korrektor bezeichnet wird, der konfiguriert ist, um als Eingang ein Signal zu empfangen, das für die Phasendifferenz repräsentativ ist, und um an seinem Ausgang ein Signal zu erzeugen, das als das erste Korrektursignal bezeichnet wird;
   - mindestens einen weiteren Korrektor ($F_2$), der als der zweite Korrektor bezeichnet wird, der konfiguriert ist, um als Eingang ein Signal zu empfangen, das das Phasenrauschen des Referenzsignals oder des Ausgangssignals des frequenzgesteuerten Oszillators darstellt oder von diesem beeinflusst wird, und um an seinem Ausgang ein Signal zu erzeugen, das als das zweite Korrektursignal bezeichnet wird; und
   - ein Mittel (NA) zum Erzeugen eines Signals ($s_u$, u) zum Regeln des frequenzgesteuerten Oszillators anhand des ersten und zweiten Korrektursignals;

   wobei das Verfahren Folgendes umfasst:

   - einen Auslegungsschritt der Phasenregelschleife; und
   - einen physischen Durchführungsschritt der so ausgelegten Phasenregelschleife;

   **dadurch gekennzeichnet, dass** der Auslegungsschritt durch ein Verfahren gemäß einem der vorherigen Ansprüche implementiert wird.

9. Verfahren nach Anspruch 8, wobei die Phasenregelschleife mindestens einen weiteren Korrektor ($F_3$) umfasst, der als dritter Korrektor bezeichnet wird, der konfiguriert ist, um als Eingang ein Signal zu empfangen, das für ein innerhalb der Schleife erzeugtes Phasenrauschen repräsentativ oder von diesem beeinflusst ist, das sich von dem Phasenrauschen des Ausgangssignals des frequenzgesteuerten Oszillators unterscheidet, und um an seinem Ausgang ein Signal zu erzeugen, das als drittes Korrektursignal bezeichnet wird, wobei das Mittel zum Erzeugen eines Regelungssignals des frequenzgesteuerten Oszillators konfiguriert ist, um das Regelungssignal auch anhand des dritten Korrektursignals zu erzeugen, wobei der Auslegungsschritt durch eine Verfahren gemäß dem Anspruch 7 implementiert wird.

10. Phasenregelschleife, umfassend:

    - einen frequenzgesteuerten Oszillator (VCO), der angepasst ist, um ein Ausgangssignal zu erzeugen, das ein Phasenrauschen aufweist;
    - einen Phasenvergleicher (CMP) zum Bestimmen einer Phasendifferenz zwischen einem Ausgangssignal des frequenzgesteuerten Oszillators und einem Referenzsignal, wobei das Referenzsignal ein Phasenrauschen aufweist;
    - einen Korrektor ($F_1$), der als erster Korrektor bezeichnet wird, der konfiguriert ist, um als Eingang ein Signal zu empfangen, das für die Phasendifferenz repräsentativ ist, und um an seinem Ausgang ein Signal zu erzeugen, das als das erste Korrektursignal bezeichnet wird;
    - mindestens einen weiteren Korrektor ($F_2$), der als der zweite Korrektor bezeichnet wird, der konfiguriert ist, um als Eingang ein Signal zu empfangen, das das Phasenrauschen des Referenzsignals oder des Ausgangssignals des frequenzgesteuerten Oszillators darstellt oder von diesem beeinflusst wird, und um an seinem Ausgang ein Signal zu erzeugen, das als das zweite Korrektursignal bezeichnet wird; und
    - ein Mittel (NA) zum Erzeugen eines Signals ($s_u$, u) zum Regeln des frequenzgesteuerten Oszillators anhand des ersten und zweiten Korrektursignals;

    **dadurch gekennzeichnet, dass** der erste und der zweite Korrektor nicht-konstante Übertragungsfunktionen aufweisen, die so ausgewählt sind, dass sie die Ablehnung des Phasenrauschens des Referenzsignals und des Phasenrauschens des Ausgangssignals des frequenzgesteuerten Oszillators in einem gleichen Frequenzband ermöglichen, und die durch Anwendung des Verfahrens $H_\infty$ unter Verwendung von Folgendem erlangt werden:

- am Eingang, einer Gewichtungsfunktion ($W_b$) des Phasenrauschens des frequenzgesteuerten Oszillators, die als erste Gewichtungsfunktion bezeichnet wird, und eine Gewichtungsfunktion ($W_{bref}$) des Phasenrauschens des Referenzsignals, die als zweite Gewichtungsfunktion bezeichnet wird, die anhand spektraler Nennleistungsdichten des Rauschens bestimmt werden; und

- am Ausgang, mindestens einer Gewichtungsfunktion ($W_\varphi, W_\varepsilon$) eines Phasenrauschens eines Ausgangssignals der Phasenregelschleife oder eines Verfolgungsfehlers des Referenzsignals, die als dritte Gewichtungsfunktion bezeichnet wird, die anhand eines Spektraldichteprofils der Phasenrauschleistung des einzuhaltenden Ausgangssignals bestimmt wird.

**11.** Phasenregelschleife nach Anspruch 10, wobei der zweite Korrektor konfiguriert ist, um als Eingang Folgendes zu empfangen:

- entweder ein Signal, das für die Phase des Referenzsignals repräsentativ ist;
- oder eine Schätzung des Phasenrauschens des Referenzsignals.

**12.** Phasenregelschleife nach Anspruch 11, die auch eine Schaltung zum Bestimmen einer Phasenrauschschätzung des Referenzsignals umfasst, umfassend:

- ein Verzögerungsmodul, das konfiguriert ist, um eine verzögerte Version um eine Zeit $T_d$ des Referenzsignals zu erzeugen;
- ein Phasenschiebermodul, das konfiguriert ist, um eine Version des Referenzsignals zu erzeugen, die eine

$$\delta\varphi - \omega_{ref} T_d = \frac{\pi}{2} + 2\pi k,$$

Phasenverschiebung $\delta\varphi$, mit $k \in Z$ aufweist, wobei $\omega_{ref}$ die Frequenz des Referenzsignals ist; und

- einen Mischer (MIX), der konfiguriert ist, um die Ausgangssignale der Verzögerungs- und Phasenschiebermodule als Eingang zu empfangen und um an seinem Ausgang ihr Produkt zu liefern;

wobei der zweite Korrektor konfiguriert ist, um die Phasenrauschschätzung des Referenzsignals als Eingang zu empfangen.

**13.** Phasenregelschleife nach Anspruch 10, wobei der zweite Korrektor konfiguriert ist, um als Eingang Folgendes zu empfangen:

- entweder ein Signal, das die Phase des Ausgangssignals des frequenzgesteuerten Oszillators repräsentativ ist;
- oder eine Schätzung des Phasenrauschens des Ausgangssignals des frequenzgesteuerten Oszillators.

**14.** Phasenregelschleife nach Anspruch 13, die auch eine Schaltung zum Bestimmen einer Phasenrauschschätzung des Ausgangssignals umfasst, umfassend:

- ein Verzögerungsmodul, das konfiguriert ist, um eine verzögerte Version um eine Zeit $T_d$ des Ausgangssignals zu erzeugen;
- ein Phasenschiebermodul, das konfiguriert ist, um eine Version des Ausgangssignals zu erzeugen, die eine

$$\delta\varphi - \omega_o T_d = \frac{\pi}{2} + 2\pi k,$$

Phasenverschiebung $\delta\varphi$, mit $k \in Z$ aufweist, wobei $\omega_0$ die Frequenz des Ausgangssignals ist; und

- einen Mischer, der konfiguriert ist, um die Ausgangssignale der Verzögerungs- und Phasenschiebermodule als Eingang zu empfangen und um an seinem Ausgang ihr Produkt zu liefern;

wobei der zweite Korrektor konfiguriert ist, um die Phasenrauschschätzung des Ausgangssignals als Eingang zu empfangen.

**15.** Phasenregelschleife nach einem der Ansprüche 10 bis 14, die auch mindestens einen weiteren Korrektor ($F_3$, $F_4$, $F_5$) umfasst, der als dritter Korrektor bezeichnet wird, der konfiguriert ist, um als Eingang ein Signal zu empfangen, das für das innerhalb der Schleife erzeugte Phasenrauschen repräsentativ oder von diesem beeinflusst ist, das sich von dem Phasenrauschen des Ausgangssignals des frequenzgesteuerten Oszillators unterscheidet, und um an seinem Ausgang ein Signal zu erzeugen, das als drittes Korrektursignal bezeichnet wird, wobei das Mittel zum Erzeugen eines Regelungssignals des frequenzgesteuerten Oszillators konfiguriert ist, um das Regelungssignal auch anhand des dritten Korrektursignals zu erzeugen.

16. Funkfrequenz-Empfangskette, umfassend:

- einen Funkfrequenz-Vorverstärker (LNA);
- einen Mischer (MRF), der konfiguriert ist, um als Eingang ein Ausgangssignal von dem Funkfrequenz-Vorverstärker und ein sinusförmiges Frequenzumwandlungssignal zu empfangen und um ein Zwischenfrequenzsignal als Ausgang bereitzustellen; und
- eine Schaltung zum Erzeugen des sinusförmigen Frequenzumwandlungssignals ;

wobei die Schaltung zum Erzeugen des sinusförmigen Frequenzumwandlungssignals eine Phasenregelschleife nach Anspruch 14 oder Anspruch 15 umfasst, wenn sie von Anspruch 14 abhängt, wobei der Mischer als Mischer der Schaltung zum Bestimmen einer Phasenrauschschätzung des Ausgangssignals verwendet wird, und einen Oszillator, der zum Erzeugen des Referenzsignals konfiguriert ist.

**Claims**

1. Design process for a phase-locked loop, of the type comprising:

- a controlled-frequency oscillator (VCO, DCO);
- a phase comparator (CMP), configured to determine a phase difference between an output signal of said controlled-frequency oscillator and a reference signal;
- a corrector ($F_1$), termed the first corrector, configured to receive as input a signal representative of said phase difference and to generate at its output a signal termed the first correction signal;
- at least one other corrector ($F_2$), termed the second corrector, configured to receive as input a signal representative of or affected by a phase noise of said reference signal or of said output signal of said controlled-frequency oscillator and to generate at its output a signal termed the second correction signal; and
- a means (AN) for generating a slaving signal (u) for said controlled-frequency oscillator on the basis of said first and second correction signals;

said process comprising a step of determining transfer functions of said correctors and being **characterized in that** said first and second correctors exhibit non-constant transfer functions, chosen so as to allow the rejection, in one and the same frequency band, of the phase noise of said reference signal and of the phase noise of said output signal of said controlled-frequency oscillator and **in that** said step is implemented, by means of a computer, by applying the $H_\infty$ method utilizing:

- at input, a weighting function ($W_b$) for a phase noise of said controlled-frequency oscillator, termed the first weighting function, and a weighting function ($W_{bref}$) for a phase noise of a reference signal, termed the second weighting function, and which are determined on the basis of nominal power spectral densities of said noise; and
- at output, at least one weighting function ($W_\varphi$, $W_\varepsilon$) for a phase noise of an output signal of the phase-lock loop or of an error in tracking said reference signal, termed the third weighting function, determined on the basis of a phase noise power spectral density template of said output signal having to be complied with.

2. Process according to Claim 1, in which said step of determining transfer functions of said correctors comprises the following sub-steps:

a) determining a nominal power spectral density of said reference signal;
b) determining a nominal power spectral density of the phase noise of said controlled-frequency oscillator;
c) determining a phase noise power spectral density template of said output signal having to be complied with;
d) determining, on the basis of said nominal power spectral densities and of said power spectral density template, at least said first, second and third weighting functions;
e) constructing an augmented system through said weightings; and
f) applying the $H_\infty$ method to said augmented system so as to synthesize the transfer functions of said correctors.

3. Process according to Claim 2, in which said step d) also comprises the determination of a weighting function at output, termed the fourth weighting function ($W_u$), for the power spectral density of said slaving signal on the basis of a power spectral density template of said slaving signal to be complied with.

4. Process according to one of Claims 2 or 3, also comprising a sub-step d') of simplifying the weighting functions determined during sub-step d), the weighting functions thus simplified being used during said sub-step e), said simplification being implemented by approximating said weighting functions by transfer functions of lower order and of smaller modulus at least over a spectral operating span of the phase-locked loop.

5. Process according to one of Claims 2 to 4, also comprising a sub-step g) of simplifying the transfer functions synthesized during said sub-step f), said simplification being implemented by approximating said transfer functions by transfer functions of lower order.

6. Process according to one of Claims 2 to 5, in which said step f) is implemented with an extra constraint, according to which the modulus of the transfer function (S) for going between said output signal of said controlled-frequency oscillator and said reference signal exhibits, in at least one spectral span, a slope of greater than or equal to +20 db/decade and preferably of greater than or equal to 40 dB/decade.

7. Process according to one of the preceding claims, in which said phase-locked loop comprises at least one other corrector ($F_3$), termed the third corrector, configured to receive as input a signal representative of or affected by a phase noise generated inside said loop, other than said phase noise of said output signal of said controlled-frequency oscillator, and to generate at its output a signal termed the third correction signal, said means for generating a slaving signal for said controlled-frequency oscillator being configured to generate said slaving signal also on the basis of said third correction signal, said step, implemented by said method $H_\infty$, of determining transfer functions of said correctors using as input also a weighting function for said phase noise other than said phase noise of said output signal of said controlled-frequency oscillator, and also determined on the basis of the power spectral density of said noise.

8. Process for fabricating a phase-locked loop, of the type comprising:

   - a controlled-frequency oscillator (VCO);
   - a phase comparator (CMP) for determining a phase difference between an output signal of said controlled-frequency oscillator and a reference signal;
   - a corrector ($F_1$), termed the first corrector, configured to receive as input a signal representative of said phase difference and to generate at its output a signal termed the first correction signal;
   - at least one other corrector ($F_2$), termed the second corrector, configured to receive as input a signal representative of or affected by a phase noise of said reference signal or of said output signal of said controlled-frequency oscillator and to generate at its output a signal termed the second correction signal; and
   - a means (AN) for generating a signal ($s_u$, u) for slaving said controlled-frequency oscillator on the basis of said first and second correction signals;

   said process comprising:

   - a step of design of said phase-locked loop; and
   - a step of physical production of the phase-locked loop thus designed;

   **characterized in that** said design step is implemented by a process according to one of the preceding claims.

9. Process according to Claim 8, in which said phase-locked loop comprises at least one other corrector ($F_3$), termed the third corrector, configured to receive as input a signal representative of or affected by a phase noise generated inside said loop, other than said phase noise of said output signal of said controlled-frequency oscillator, and to generate at its output a signal termed the third correction signal, said means for generating a slaving signal for said controlled-frequency oscillator being configured to generate said slaving signal also on the basis of said third correction signal, said design step being implemented by a process according to Claim 7.

10. Phase-locked loop comprising:

    - a controlled-frequency oscillator (VCO) adapted for generating an output signal having a phase noise ;
    - a phase comparator (CMP) for determining a phase difference between an output signal of said controlled-frequency oscillator and a reference signal, said reference signal having a phase noise;

- a corrector ($F_1$), termed the first corrector, configured to receive as input a signal representative of said phase difference and to generate at its output a signal termed the first correction signal;
- at least one other corrector ($F_2$), termed the second corrector, configured to receive as input a signal representative of or affected by a phase noise of said reference signal or of said output signal of said controlled-frequency oscillator and to generate at its output a signal termed the second correction signal; and
- a means (AN) for generating a signal ($s_u$, u) for slaving said controlled-frequency oscillator on the basis of said first and second correction signals;

**characterized in that** said first and second correctors exhibit non-constant transfer functions, chosen so as to allow the rejection, in one and the same frequency band, of the phase noise of said reference signal and of the phase noise of said output signal of said controlled-frequency oscillator and obtained by applying the $H_\infty$ method utilizing:

- at input, a weighting function ($W_b$) for the phase noise of said controlled-frequency oscillator, termed the first weighting function, and a weighting function ($W_{bref}$) for the phase noise of a reference signal, termed the second weighting function, and which are determined on the basis of nominal power spectral densities of said noises; and
- at output, at least one weighting function ($W_\varphi$, $W_\varepsilon$) for a phase noise of an output signal of the phase-lock loop or of an error in tracking said reference signal, termed the third weighting function, determined on the basis of a phase noise power spectral density template of said output signal having to be complied with.

11. Phase-locked loop according to Claim 10, in which said second corrector is configured to receive as input:

- either a signal representative of the phase of said reference signal;
- or an estimation of the phase noise of said reference signal.

12. Phase-locked loop according to Claim 11, also comprising a circuit for determining an estimation of the phase noise of said reference signal comprising:

- a delayer module, configured to generate a version delayed by a time $T_d$ of said reference signal;
- a phase-shifter module, configured to generate a version of said reference signal exhibiting a phase shift $\delta\varphi$,

$$\delta\varphi - \omega_{ref} T_d = \frac{\pi}{2} + 2\pi k, k \in Z$$

with , where $\omega_{ref}$ is the frequency of said reference signal; and
- a mixer (MIX) configured to receive as input the output signals of said delayer and phase-shifter modules and to provide their product at its output;

said second corrector being configured to receive as input the estimation of the phase noise of said reference signal.

13. Phase-locked loop according to Claim 10, in which said second corrector is configured to receive as input:

- either a signal representative of the phase of said output signal of said controlled-frequency oscillator;
- or an estimation of the phase noise of said output signal of said controlled-frequency oscillator.

14. Phase-locked loop according to Claim 13, also comprising a circuit for determining an estimation of the phase noise of said output signal comprising:

- a delayer module, configured to generate a version delayed by a time $T_d$ of said output signal;
- a phase-shifter module, configured to generate a version of said output signal exhibiting a phase shift $\delta\varphi$, with

$$\delta\varphi - \omega_o T_d = \frac{\pi}{2} + 2\pi k,$$

$k \in Z$, where $\omega_o$ is the frequency of said output signal; and
- a mixer configured to receive as input the output signals of said delayer and phase-shifter modules and to provide their product at its output;

said second corrector being configured to receive as input said estimation of the phase noise of said output signal.

15. Phase-locked loop according to one of Claims 10 to 14, also comprising at least one other corrector ($F_3$, $F_4$, $F_5$), termed the third corrector, configured to receive as input: a signal representative of or affected by a phase noise generated inside said loop, other than said phase noise of said output signal of said controlled-frequency oscillator, and to generate at its output a signal termed the third correction signal, the means for generating a slaving signal for said controlled-frequency oscillator being configured to generate said slaving signal also on the basis of said third correction signal.

16. Radiofrequency reception chain comprising:

- a radiofrequency preamplifier (LNA);
- a mixer (MRF) configured to receive as input an output signal of said radiofrequency preamplifier and a frequency conversion sinusoidal signal, and to provide as output a signal at intermediate frequency; and
- a circuit for generating said frequency conversion sinusoidal signal;

in which said circuit for generating said frequency conversion sinusoidal signal comprises a phase-locked loop according to Claim 14, or Claim 15 when it depends on Claim 14, using said mixer in the guise of mixer of said circuit for determining an estimation of the phase noise of said output signal, and an oscillator configured to generate said reference signal.

FIG.1

FIG.2

FIG.3

FIG.4a

FIG.4b

FIG.6a

FIG.6b

FIG.7

FIG.8

FIG.9

FIG.10

FIG.11

FIG.12a

FIG.12b

FIG.13a

FIG.13b

FIG.13c

FIG.13d

FIG.14

FIG.15

FIG.16

FIG.17

FIG.18

FIG.19

FIG.20

FIG.21

FIG.22

FIG.23

FIG.24

FIG.25

FIG.26

FIG.27

## RÉFÉRENCES CITÉES DANS LA DESCRIPTION

**Documents brevets cités dans la description**

- US 20140070859 A1

**Littérature non-brevet citée dans la description**

- **JOHEN E. BIBEL ; STEPHEN MALYEVAC.** Guidelines for the selection of weighting functions for H-infinity control. *AD-A251 781 Naval Surface Warfare Center,* Janvier 1992, URL: http://www.dtic.mil/dtic/tr/fulltext/u2/a251781.pdf.
- **SCORLETTI G. ; FROMION V.** Automatique fréquentielle avancée. *polycopie de cours, Sciences de l'ingénieur, http://cel.archives-ouvertes.fr/cel-00423848*
- **S. SKOGESTAD ; I. POSTLETHWAITE.** Multivariable Feedback Control, Analysis and Design. John Wiley and Sons Chischester, 2005
- **W. CHAIVIPAS ; A. MATSUZAWA.** Analysis and Design of Direct Reference Feed-Forward. Compensation for Fast-Settling All-Digital Phase-Locked Loop. *IEICE TRANS. ELECTRON.,* Avril 2007, vol. E90-C (4

- **B. INDU RANI ; C.K. ARAVIND ; G. SARAVANA ILANGO ; C. NAGAMANI.** A three phase PLL with a dynamic feed forward frequency estimator for synchronization of grid connected converters under wide frequency variations. *Electrical Power and Energy Systems,* 2012, vol. 41, 63-70
- **R.B.STASZEWSKI et al.** All-Digital TX Frequency Synthesizer and Discrete-time Receiver for Bluetooth Radio in 130-nm CMOS. *IEEE Journal of Solid-State Circuits,* Décembre 2004, vol. 39 (12
- **R.B.STASZEWSKI ; P.T. BALSARA.** Phase-Domain All-Digital Phase-Locked Loop. *IEEE Transaction on Circuits and Systems - II: Express Briefs,* Mars 2005, vol. 52 (3